# EUROPEAN PATENT APPLICATION

(11) **EP 4 730 921 A1**
(43) Date of publication of application: **22.04.2026**
(21) Application number: 25793364.8
(22) Date of filing: 02.04.2025
(51) Int. Cl.: H05K 1/02

(54) **FLEXIBLE PRINTED CIRCUIT ASSEMBLY, ROTATING SHAFT ASSEMBLY AND FOLDABLE ELECTRONIC DEVICE**

(30) Priority: 22.04.2024 CN 202410486967
(71) Applicant: Huawei Technologies Co., Ltd., Shenzhen, Guangdong 518129 (CN)
(72) Inventor: YU, Weidong, Shenzhen, Guangdong 518129 (CN); MAO, Weihua, Shenzhen, Guangdong 518129 (CN); GUO, Qingfeng, Shenzhen, Guangdong 518129 (CN); HUANG, Min, Shenzhen, Guangdong 518129 (CN); LIU, Yong, Shenzhen, Guangdong 518129 (CN); LI, Mengen, Shenzhen, Guangdong 518129 (CN)
(74) Representative: Epping - Hermann - Fischer
(86) International application number: PCT/CN2025/086801
(87) International publication number: WO 2025/223167

(57) **Abstract**

Embodiments of this application provide a flexible circuit board assembly, a hinge assembly, and a foldable electronic device, and pertain to the field of electronic device technologies. A flexible circuit board passes through a hinge through a through hole of the hinge, a first attachment member is attached to a second attachment member in the through hole, and a snap-fit member is in a snap-fit with the hinge, to implement high firmness of limiting of the flexible circuit board, avoid falling off of the flexible circuit board in scenarios such as drop, and help reduce a risk of breakage of the hinge. In addition, the first attachment member and the second attachment member are located on a same side of the flexible circuit board. While strong attachment is ensured, this helps reduce thickness space occupied by the attachment member in the hinge, improve strength of the hinge, and reduce a risk of breakage of the hinge in scenarios such as drop. In addition, the snap-fit between the snap-fit member and the hinge is detachable, and an attachment fit between the first attachment member and the second attachment member may also be separated under an external force, so that ease of detachment of the flexible circuit board from the hinge can be implemented, facilitating disassembly in scenarios such as repair.

## Description

This application claims priority to Chinese Patent Application No. 202410486967.9, filed with the China National Intellectual Property Administration on April 22, 2024 and entitled "FLEXIBLE CIRCUIT BOARD ASSEMBLY, HINGE ASSEMBLY, AND FOLDABLE ELECTRONIC DEVICE", which is incorporated herein by reference in its entirety.

### TECHNICAL FIELD

This application relates to the field of electronic device technologies, and in particular, to a flexible circuit board assembly, a hinge assembly, and a foldable electronic device.

### BACKGROUND

As flexible display technologies gradually become mature, display manners of electronic devices have great changes. One of the changes is emergence of foldable electronic devices such as foldable mobile phones, foldable computers, and the like. The foldable electronic device may flexibly change switching modes based on different use scenarios and also has a high display-to-body ratio and high definition. In an example of a foldable mobile phone, after being folded, the foldable mobile phone has only a size of a conventional mobile phone, and may be carried around conveniently. In addition, after being unfolded, the foldable mobile phone may have a display size of a tablet computer. These features make a foldable device one of popular products.

The foldable electronic device includes at least two middle frames, a hinge, and a flexible circuit board. The two middle frames are located on two sides of the hinge, and the two middle frames implement a rotatable fit by using the hinge, to cause the two middle frames to rotate relative to each other, so that the electronic device may have a folded state, an intermediate state, and an unfolded state. A flexible circuit board (flexible printed circuit, FPC for short) is a structure that can be bent and can implement circuit connectivity. The flexible circuit board generally passes through the hinge, and is separately connected to electronic components in the two middle frames to implement conduction. Usually, the flexible circuit board is fastened and limited to the hinge in a magnetic attraction manner. For example, a magnetic attraction member is fastened in a through hole of the hinge, and a magnetic attraction member is fastened to the flexible circuit board. The two magnetic attraction members are respectively located on two opposite sides of the flexible circuit board, and the flexible circuit board is fastened to the hinge through attraction of the two magnetic attraction members.

The foregoing solution of fastening the flexible circuit board to the hinge greatly affects strength of the hinge, and increases a risk of breakage of the hinge in scenarios such as drop.

### SUMMARY

Embodiments of this application provide a flexible circuit board assembly, a hinge assembly, and a foldable electronic device, to improve strength of a hinge while high firmness of fastening between a flexible circuit board and the hinge is implemented.

A first aspect of embodiments of this application provides a flexible circuit board assembly, configured to cooperate with a hinge of a foldable electronic device. The flexible circuit board assembly includes a flexible circuit board, a first attachment member, and a first snap-fit member. The flexible circuit board is configured to pass through the hinge through a through hole of the hinge, so that two ends of the flexible circuit board may be respectively located on two sides of the hinge. In this way, electrical connections between electronic components in two middle frames of the foldable electronic device can be implemented through the flexible circuit board, and a part of the flexible circuit board is located in the through hole of the hinge. A pass-through direction of the flexible circuit board intersects with a thickness direction of the hinge and a length direction of the hinge.

The first attachment member is disposed on the flexible circuit board, and one end that is of the first attachment member and that faces away from the flexible circuit board in the thickness direction is configured to adsorb and connect to a second attachment member in the through hole. To be specific, when the flexible circuit board passes through the hinge through the through hole, the first attachment member may be placed in the through hole of the hinge and attached to the second attachment member in the hinge, to implement limiting and fastening of the flexible circuit board. For example, a movement of the flexible circuit board relative to the hinge in the thickness direction can be limited, and displacement of the flexible circuit board in the thickness direction in scenarios such as daily use or drop is limited, so that the flexible circuit board and the hinge are assembled and fastened.

In addition, the end that is of the first attachment member and that faces away from the flexible circuit board is attached to the second attachment member, that is, the first attachment member and the second attachment member are located on a same side of the flexible circuit board. While a high attachment force between the first attachment member and the second attachment member is ensured to meet firmness of limiting, thicknesses of the first attachment member and the second attachment member can be reduced, that is, thickness space occupied in the hinge can be reduced, and strength of the hinge can be improved, thereby reducing a risk of breakage of the hinge in scenarios such as drop and impact, and further improving a service life and use experience.

The snap-fit member is disposed on the flexible circuit board, and the snap-fit member is configured to be inserted into the through hole in the pass-through direction of the flexible circuit board, and be in a snap-fit with the hinge. To be specific, when the flexible circuit board passes through the hinge through the through hole, the snap-fit member may be inserted into the through hole in the pass-through direction of the flexible circuit board, and is in a snap-fit with the hinge, to implement limiting and fastening of the flexible circuit board. For example, movement of the flexible circuit board relative to the hinge in the length direction and a width direction (the pass-through direction) may be limited, and displacement of the flexible circuit board in scenarios such as daily use or drop is limited, thereby further improving firmness of limiting of the flexible circuit board to the hinge, and improving assembly stability and reliability of the flexible circuit board. Phenomena such as movement, falling off, or the like of the flexible circuit board in scenarios such as drop and impact are reduced or avoided, and a risk of breakage of the hinge caused by collision between the hinge and the flexible circuit board or the first attachment member can also be reduced, thereby further improving a service life and use experience.

The snap-fit member can also be detached from the hinge, and the first attachment member and the second attachment member can also be detached under an action of a specific external force. For example, the other end of the flexible circuit board is pulled backward (for example, opposite to the pass-through direction), to cause the snap-fit member to be detached from the hinge, and the first attachment member to be detached from the second attachment member, so that the flexible circuit board can be detached from the hinge, thereby significantly improving ease of detachment of the flexible circuit board, and facilitating disassembly in scenarios such as repair.

In a possible implementation, the flexible circuit board includes a first surface and a second surface that are opposite in the thickness direction, at least a part of the snap-fit member and the first attachment member are respectively located on the first surface and the second surface, and the at least part of the snap-fit member, a part of the flexible circuit board, and the first attachment member are sequentially stacked in the thickness direction.

One end that is of the first attachment member and that faces away from the second surface is configured to abut against the second attachment member. To be specific, when the flexible circuit board is fastened to and assembled with the hinge via the snap-fit member and the first attachment member, one end that is of the first attachment member and that faces away from the flexible circuit board abuts against and is attached to the second attachment member, and one end that is of the at least part of the snap-fit member and that faces away from the first surface is configured to abut against an inner wall that is of the through hole and that is opposite to the second attachment member in the thickness direction. In other words, the second attachment member, the first attachment member, the part of the flexible circuit board, and the at least part of the snap-fit member are sequentially stacked in the thickness direction, the second attachment member may abut against and be fastened to one of two opposite inner walls of the through hole in the thickness direction, and the at least part of the snap-fit member abuts against the other one of the two inner walls, that is, a stacked structure formed by the second attachment member, the first attachment member, the flexible circuit board, and the at least part of the snap-fit member may jointly fill the through hole in the thickness direction, and there may be no gap between the stacked structure and the hinge (or two inner walls of the through hole in the thickness direction) in the thickness direction. In scenarios such as drop and impact, the flexible circuit board assembly and the hinge are not prone to colliding and moving, so that strength of the hinge against drop is further improved, and a risk of breakage of the hinge is significantly reduced.

In a possible implementation, the snap-fit member includes a first main body part and at least two limiting parts, and the first main body part is attached and fastened to the first surface.

At least two of the limiting parts are respectively located on two opposite sides of the first main body part in the pass-through direction, the limiting part protrudes from a surface that is of the first main body part and that faces the first attachment member, the limiting part and the first main body part form accommodating space, the first attachment member is located in the accommodating space, and the accommodating space may be used to play a positioning role for assembly of the first attachment member and the snap-fit member, facilitating accurate positioning of the first attachment member and the snap-fit member, and ensuring implementation of an attachment between the first attachment member and the second attachment member when the snap-fit member and the hinge are in a snap-fit.

The limiting parts located on two opposite sides of the first main body part in the pass-through direction may further implement limiting and fastening of the first attachment member, to limit displacement of the first attachment member relative to the snap-fit member in the pass-through direction, and improve movement consistency between the snap-fit member and the first attachment member in the pass-through direction, so that damage to the flexible circuit board cannot be caused by pulling the flexible circuit board due to an excessively large displacement amount of adhesive layers such as a first bonding layer between the flexible circuit board and the snap-fit member and a second bonding layer between the flexible circuit board and the first attachment member in a process in which the flexible circuit board is pulled during assembly or disassembly of the flexible circuit board assembly.

In a possible implementation, the at least two limiting parts are respectively distributed on two opposite ends of the first main body part in the length direction, to ensure consistency effect of positioning and limiting of the first attachment member in the length direction, enhance positioning and limiting strength of the first attachment member, and improve positioning and limiting effect of the limiting part on the first attachment member.

An avoidance gap is provided between limiting parts distributed on two opposite ends of the snap-fit member in the length direction, and a part of the flexible circuit board is located in the avoidance gap, to avoid the flexible circuit board, so that the flexible circuit board can be smoothly fastened between the first main body part and the first attachment member, thereby reducing damage to the flexible circuit board.

In a possible implementation, the snap-fit member further includes a first snap-fit part, the first snap-fit part is disposed on each of the two opposite ends of the first main body part in the length direction, and the first snap-fit part is configured to be in a snap-fit with a second snap-fit part in the through hole. It is ensured that limiting and fastening to the hinge can be implemented via the first snap-fit between the snap-fit part and the second snap-fit part when the snap-fit member is inserted into the through hole in the pass-through direction, and movement of the snap-fit member and the flexible circuit board relative to the hinge is limited on a plane in which the width direction and the length direction are located.

In a possible implementation, the first snap-fit protrudes from the surface that is of the first main body part and that faces the first attachment member, and the first snap-fit part, the limiting part, and the first main body part jointly form the accommodating space. The first snap-fit part located at the two ends of the first main body part in the length direction may also play a positioning role for the first attachment member, facilitating accurate positioning of the first attachment member and the snap-fit member, and facilitates assembly. The first snap-fit part may also limit and fasten the first attachment member, to limit displacement of the first attachment member relative to the snap-fit member in the length direction, further enhance limiting strength between the snap-fit member and the first attachment member, and reduce pulling damage to the flexible circuit board.

In a possible implementation, the first snap-fit part and the second snap-fit part are in a snap-fit through an elastic protrusion and a recessed groove, one of the first snap-fit part and the second snap-fit part includes the elastic protrusion, and the other one includes the recessed groove that is in a snap-fit with the elastic protrusion. For example, the first snap-fit part includes the elastic protrusion, and the second snap-fit part includes the recessed groove. When the flexible circuit board is pulled to assemble the flexible circuit board assembly with the hinge, the snap-fit member moves in the pass-through direction of the flexible circuit board and is inserted into the through hole. The elastic protrusion may be pressed by an inner side wall of the through hole, that is, the elastic protrusion is pressed in a direction toward the first main body part. The flexible circuit board is continuously pulled for insertion of the snap-fit member, the elastic protrusion moves to a position of the recessed groove, and the elastic protrusion is restored under a rebound action, that is, the elastic protrusion moves away from the first main body part, so that the elastic protrusion is accommodated in and in the snap-fit with the recessed groove. In this way, the snap-fit member can be connected to and assembled with the hinge via a fit between the elastic protrusion and the recessed groove.

In scenarios such as detaching the flexible circuit board, the flexible circuit board is pulled backward, so that the snap-fit member moves backward, and the elastic protrusion may be pressed again. In this way, the flexible circuit board can be detached from the hinge. The structure design is simple, and facilitates production implementation.

In a possible implementation, the first snap-fit part includes the elastic protrusion, and the second snap-fit part is the recessed groove. This helps simplify a design of an internal structure of the through hole of the hinge, and reduce difficulty in designing and forming the hinge, and also helps ensure strength of the hinge, thereby facilitating implementation.

For example, the first snap-fit part includes a connecting arm and a snap-fit arm, the connecting arm is connected to the first main body part, the connecting arm is provided on each of two sides of the snap-fit arm in the pass-through direction, two end parts of the snap-fit arm are respectively connected to the connecting arms, and a middle part of the snap-fit arm protrudes away from the accommodating space to form the elastic protrusion. The part of the snap-fit arm forms the elastic protrusion to implement a snap-fit with the recessed groove on the hinge, and the two end parts of the snap-fit arm are both connected to the first main body part through the connecting arms, which helps improve strength of the snap-fit arm, and further improve firmness of the snap-fit between the elastic protrusion of the snap-fit arm and the recessed groove on the hinge. This improves reliability and stability of the snap-fit between the snap-fit member and the hinge, and helps reduce phenomena such as movement or falling off of the flexible circuit board in scenarios such as drop. In a possible implementation, a first abutting surface is provided on a side of the first attachment member in the pass-through direction.

The snap-fit member further includes a notch structure, where the notch structure is located on a side of the first main body part in the pass-through direction, and the first abutting surface is exposed through the notch structure, for example, the first abutting surface may be exposed from the notch structure in the pass-through direction. The notch structure is configured to accommodate a part of a first boss in the through hole, and the first abutting surface is configured to abut against and fit the first boss, to limit displacement of the flexible circuit board in the pass-through direction. In this way, when the flexible circuit board is pulled in the pass-through direction, to assemble the flexible circuit board assembly with the hinge, abutting of the first abutting surface against the first boss can limit further movement of the flexible circuit board assembly, thereby implementing accurate positioning of the snap-fit member and the first attachment member on the hinge, and avoiding damage caused by pulling the flexible circuit board. For example, in a process of pulling the flexible circuit board, when the first boss abuts against the first abutting surface, the first snap-fit part is in the snap-fit with the second snap-fit part, and the first attachment member is attached to the second attachment member, to avoid problems such as excessively pulling of the flexible circuit board or an inaccurate assembly.

In addition, the first abutting surface of the first attachment member abuts against the first boss, to reduce impact on the snap-fit member in an assembly process of the flexible circuit board assembly. In this way, when a width (a width in the pass-through direction) of the first bonding layer located between the snap-fit member and the flexible circuit board is narrow, firmness of bonding between the snap-fit member and the flexible circuit can also be ensured, and the narrow first bonding layer can facilitate bending of the flexible circuit board.

In a possible implementation, the notch structure is provided between the first snap-fit part and the limiting part located on the side of the first main body part in the pass-through direction, facilitating forming. For example, when the limiting part is formed on the first snap-fit part, a gap is reserved between the limiting part and the first snap-fit part to form the notch structure. A forming manner is simple and easy to implement, and helps reduce costs.

In a possible implementation, a surface that is of the limiting part located on the side of the first main body part in the pass-through direction and that faces away from the accommodating space forms a second abutting surface, and the second abutting surface is configured to abut against and fit the second boss in the through hole. Abutting of the second boss against the second abutting surface can limit the flexible circuit board can in the pass-through direction, and implement accurate positioning of the snap-fit member and the first attachment member on the hinge, thereby avoiding damage caused by pulling the flexible circuit board.

The limiting part abuts against the second boss, and no notch structure needs to be designed. This helps reduce structural design difficulty of the snap-fit member, and reduce design and manufacturing costs.

In a possible implementation, the first bonding layer is further included, where the first bonding layer is located between the first main body part and the first surface, and the snap-fit member and the flexible circuit board are fastened through the first bonding layer.

The flexible circuit board further includes a second bonding layer, the second bonding layer is located between the flexible circuit board and the first attachment member, and the first attachment member and the flexible circuit board are fastened through the second bonding layer.

The width of the first bonding layer in the pass-through direction is less than a width of the second bonding layer in the pass-through direction. In this case, the width of the first bonding layer is narrow, and the first bonding layer imposes a small constraint on the first surface in the width direction, so that impact of the first bonding layer on bending of the flexible circuit board can be reduced or avoided, to facilitate bending of the flexible circuit board.

In a possible implementation, the flexible circuit board includes a second main body part and an extension part, the extension part is located on two sides of the second main body part in the length direction, and the extension part and a part of the second main body part are located in the accommodating space. The extension part is located in the accommodating space, to play a positioning role for assembly of the snap-fit member and the flexible circuit board, and implement accurate positioning and assembly of the snap-fit member on the flexible circuit board, thereby facilitating accurate positioning of the snap-fit member and the first attachment member on the flexible circuit board.

In a possible implementation, a first positioning hole is provided on each of two ends of the first main body part in the length direction, a second positioning hole is provided on the extension part, a third positioning hole is provided on each of two ends of the first attachment member in the length direction, and center lines of the first positioning hole, the second positioning hole, and the third positioning hole overlap in the thickness direction.

The first positioning hole, the second positioning hole, and the third positioning hole may be configured to implement auxiliary positioning for the first body part, the snap-fit member, and the flexible circuit board during assembly, to further improve positioning accuracy. For example, after the first attachment member, the part of the flexible circuit board, and the snap-fit member are sequentially stacked, a positioning rod may be used to successively pass through the first positioning hole, the second positioning hole, and the third positioning hole in the thickness direction, and the positioning rod may overlap the center lines of the first positioning hole, the second positioning hole, and the third positioning hole. In this way, the snap-fit member, the flexible circuit board, and the first attachment member implement accurate positioning and assembly.

In a possible implementation, a hole diameter of the first positioning hole may be equal to a hole diameter of the third positioning hole, and a hole diameter of the second positioning hole may be separately greater than the hole diameter of the first positioning hole and the hole diameter of the second positioning hole. The hole diameter of the second positioning hole on the flexible circuit board is large, so that collision or contact between the positioning rod and a circuit structure on the flexible circuit board may be reduced or avoided in an assembly process, for example, when the positioning rod is used to assist positioning, to ensure electrical connection performance of the flexible circuit board.

A second aspect of embodiments of this application provides a hinge assembly, including at least a hinge and the flexible circuit board assembly according to any implementation of the first aspect. A through hole is provided on the hinge, and a second attachment member is disposed in the hinge. The flexible circuit board passes through the hinge through the through hole. One end that is of a first attachment member and that faces away from the flexible circuit board in a thickness direction of the hinge is attached to the second attachment member. A snap-fit member is inserted into the through hole in a pass-through direction of the flexible circuit board, and is in a snap-fit with the hinge. In this way, the flexible circuit board may implement limiting to and fitting with the hinge by using the snap-fit member and the first attachment member, and has high assembly stability and reliability, so that movement or falling-off of the flexible circuit board in scenarios such as drop can be reduced or avoided, and a risk of breakage of the hinge caused by impact on the hinge can be reduced. In addition, the first attachment member and the second attachment member are located on a same side of the flexible circuit board. Under a condition that a requirement for attachment firmness is met, thickness occupied space is reduced to enhance strength of the hinge, and further improve strength of the hinge against drop. A snap-fit between the snap-fit member and the hinge and an attachment fit between the first attachment member and the second attachment member may implement ease of detachment of the flexible circuit board from the hinge, facilitating disassembly in scenarios such as repair.

In a possible implementation, the second attachment member is located on an inner side wall of the through hole in the thickness direction, the second attachment member, the first attachment member, the part of the flexible circuit board, and the at least part of the snap-fit member are sequentially stacked in the thickness direction, and one end that is of the at least part of the snap-fit member and that faces away from the flexible circuit board abuts against an inner wall that is of the through hole and that is opposite to the second attachment member in the thickness direction. In this way, there may be no gap between the hinge and the stacked structure formed by the second attachment member, the first attachment member, the flexible circuit board, and the at least part of the snap-fit member in the thickness direction, thereby further improving strength of the hinge against drop.

In a possible implementation, a second snap-fit part is separately disposed on each of two opposite inner side walls of the through hole in a length direction, and the second snap-fit part and a first snap-fit part of the snap-fit member are in a snap-fit with a recessed groove through an elastic protrusion. For example, the second snap-fit part may include the recessed groove, the first snap-fit part may include the elastic protrusion, and the recessed groove of the second snap-fit part is in a snap-fit with the elastic protrusion of the first snap-fit part. The first snap-fit part and the second snap-fit part implement a snap-fit between the snap-fit member and the hinge. The structure is simple and easy to implement.

In a possible implementation, an inner wall of the through hole is provided with a mounting groove, and the second attachment member is disposed in the mounting groove. The mounting groove may be provided to improve firmness of fastening of the second attachment member to the hinge, thereby helping improve firmness of fastening and limiting of the flexible circuit board assembly to the hinge.

In a possible implementation, the through hole is provided with a protruding first boss, and the first boss is located on a side of the pass-through direction in the through hole. The first boss partially extends into a notch structure on the snap-fit member, and the first boss abuts against and fits a first abutting surface on the first attachment member, to limit displacement of the flexible circuit board in the pass-through direction. In a process of assembling the flexible circuit board assembly and the hinge, accurate positioning of the snap-fit member and the first attachment member on the hinge may be implemented through abutting of the first boss against the first abutting surface, thereby avoiding damage caused by pulling the flexible circuit board.

In a possible implementation, the through hole is provided with a protruding second boss, the second boss is located on a side of the pass-through direction in the through hole, and the second boss abuts against and fits a second abutting surface on a limiting part of the snap-fit member, so that the flexible circuit board can also be limited in the pass-through direction, and the snap-fit member and the first attachment member can be accurately positioned on the hinge, thereby avoiding damage caused by pulling the flexible circuit board. In addition, the limiting part abuts against the second boss, and no notch structure needs to be designed. This helps reduce structural design difficulty of the snap-fit member, and reduce design and manufacturing costs.

A third aspect of embodiments of this application provides a foldable electronic device, including at least two middle frames and the hinge assembly according to any implementation of the second aspect. The two middle frames are respectively located on two sides of the hinge assembly, and the two middle frames are in a rotatable fit through the hinge assembly.

In a possible implementation, a flexible display is further included. The flexible display is disposed on the hinge assembly and the middle frame, and the flexible display is located at least on outer surfaces of the middle frame and the hinge assembly. When the electronic device is in a folded state, the outer surfaces of the two middle frames face away from each other, and the outer surface of the hinge assembly and the outer surfaces of the middle frames are located on a same side of the electronic device.

In a possible implementation, in a thickness direction, the flexible display is located on a side that is of a second attachment member and that faces away from a snap-fit member, that is, a first surface of the flexible circuit board is closer to an inner surface of the hinge assembly, and a second surface is closer to the outer surface of the hinge assembly. When the electronic device is in a folded state, a part that is of the first surface of the flexible circuit board and that is located in the first middle frame is opposite to a part that is of the first surface of the flexible circuit board and that is located in the second middle frame, and a part that is of the second surface of the flexible circuit board and that is located in the first middle frame is opposite to a part that is of the second surface of the flexible circuit board and that is located in the second middle frame. A width of a first bonding layer between the snap-fit member and the first surface may be less than a width of a second bonding layer between a first attachment member and the second surface. The first bonding layer imposes a small constraint on the first surface in a width direction, so that impact of the first bonding layer on bending of the flexible circuit board is reduced or avoided, to facilitate bending of the flexible circuit board.

### BRIEF DESCRIPTION OF DRAWINGS

FIG. 1 is a diagram of a structure of a foldable electronic device in a folded state according to an embodiment of this application;
FIG. 2 is a diagram of a structure of the foldable electronic device shown in FIG. 1 in an intermediate state;
FIG. 3 is a diagram of a structure of the foldable electronic device shown in FIG. 1 in an unfolded state;
FIG. 4 is a schematic exploded view of a structure of the foldable electronic device shown in FIG. 1;
FIG. 5 is a diagram of assembling a flexible circuit board and a hinge in an electronic device in a related technology;
FIG. 6 is a schematic exploded view of a partial structure of a foldable electronic device according to an embodiment of this application;
FIG. 7 is a schematic exploded view of a structure of the hinge assembly in FIG. 6;
FIG. 8 is a diagram of a process state of assembling a flexible circuit board assembly and a hinge in the hinge assembly in FIG. 7;
FIG. 9 is a diagram of a structure obtained after a flexible circuit board and a hinge in the hinge assembly shown in FIG. 7 are assembled;
FIG. 10 is a schematic sectional view of the structure of the hinge assembly in FIG. 9 along an A-A plane;
FIG. 11 is a schematic sectional view of the structure of the hinge assembly in FIG. 9 along a B-B plane;
FIG. 12 is a schematic locally enlarged view of a structure at a fitting part of a first snap-fit part and a second snap-fit part in FIG. 11;
FIG. 13 is a schematic exploded view of a partial structure of the flexible circuit board assembly in FIG. 7;
FIG. 14 is a schematic sectional view of a structure of the hinge in the hinge assembly in FIG. 9;
FIG. 15 is a schematic front sectional view of a partial structure of the electronic device in FIG. 6;
FIG. 16 is a schematic locally enlarged view of a structure of the flexible circuit board assembly in FIG. 7 at the snap-fit member;
FIG. 17 is another schematic exploded view of a partial structure of the flexible circuit board assembly in FIG. 7;
FIG. 18 is a diagram of a structure of the snap-fit member in FIG. 16;
FIG. 19 is a schematic locally enlarged view of a structure of the flexible circuit board assembly in FIG. 16 at one end of the snap-fit member;
FIG. 20 is another schematic sectional view of a structure of the hinge assembly in FIG. 9;
FIG. 21 is a schematic locally enlarged sectional view of a structure of the hinge assembly in 20; and
FIG. 22 is another schematic locally enlarged sectional view of a structure of a hinge assembly according to an embodiment of this application.

### Reference numerals:

100: electronic device;
101: hinge assembly;
10: hinge;
11: through hole;
111: second snap-fit part; 112: mounting groove; 113: first boss; 114: second boss;
12: second attachment member;
13: third bonding layer;
20: flexible circuit board assembly;
21: snap-fit member; 21a: accommodating space;
211: first main body part; 2111: first positioning hole;
212: first snap-fit part; 212a: elastic protrusion; 2121: snap-fit arm; 2122: connecting arm;
213: limiting part; 2131: second abutting surface;
214: notch structure;
22: first attachment member;
221: first abutting surface; 222: third positioning hole;
23: flexible circuit board; 23a: first surface; 23b: second surface;
231: second main body part; 232: extension part; 2321: second positioning hole;
24: first bonding layer;
25: second bonding layer;
26: electrical connection component;
27: film;
102: middle frame; 102a: first middle frame; 102b: second middle frame;
103: flexible display;
104: rear cover.

### DESCRIPTION OF EMBODIMENTS

Terms used in implementations of this application are only used to explain specific embodiments of this application, but are not intended to limit this application.

A foldable electronic device provided in embodiments of this application may include but is not limited to a foldable fixed terminal or mobile terminal like a mobile phone, a tablet computer, a notebook computer, an ultra-mobile personal computer (ultra-mobile personal computer, UMPC for short), a handheld computer, a touch television, a walkie-talkie, a netbook, a POS terminal, a personal digital assistant (personal digital assistant, PDA for short), a wearable device, or a virtual reality device.

For example, the foldable electronic device is a foldable mobile phone. The foldable mobile phone may be a foldable mobile phone with a screen that folds outward, or the foldable mobile phone may be a foldable mobile phone with a screen that folds partially inward and partially outward.

In embodiments of this application, a foldable mobile phone with a screen that folds outward is used as an example for description.

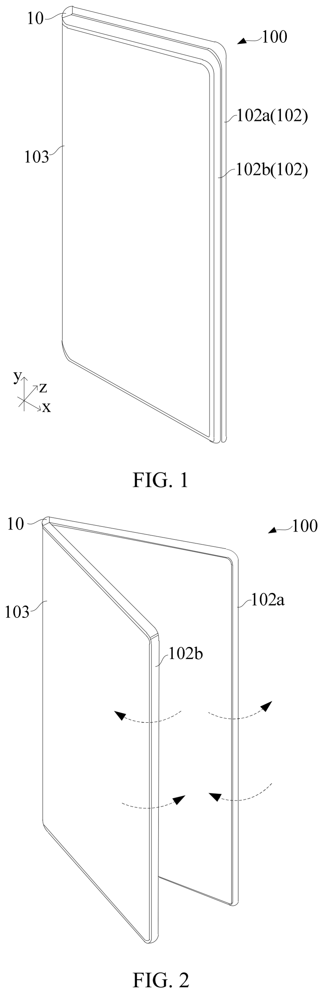

FIG. 1 is a diagram of a structure of a foldable electronic device in a folded state according to an embodiment of this application.

As shown in FIG. 1, the foldable electronic device 100 may include a hinge 10 and a middle frame 102. There may be at least two middle frames 102. For example, there are two middle frames 102: a first middle frame 102a and a second middle frame 102b. The first middle frame 102a and the second middle frame 102b are respectively located on two sides of the hinge 10, and the first middle frame 102a and the second middle frame 102b are connected to the hinge 10.

The hinge 10 may be a structural component configured to connect the two middle frames 102 and allow the two middle frames 102 to rotate relative to each other. The first middle frame 102a and the second middle frame 102b may implement a rotatable fit through the hinge 10, so that the first middle frame 102a and the second middle frame 102b may rotate relative to each other.

The first middle frame 102a and the second middle frame 102b can be folded relative to each other to a closed state. Refer to FIG. 1. For example, when the first middle frame 102a and the second middle frame 102b are in the closed state, the first middle frame 102a and the second middle frame 102b can be completely closed to be parallel to each other (a slight deviation is allowed). In this case, the entire electronic device 100 is in the closed state, which is also referred to as the folded state.

FIG. 2 is a diagram of a structure of the foldable electronic device shown in FIG. 1 in an intermediate state.

As shown in FIG. 2, the first middle frame 102a and the second middle frame 102b can rotate relative to each other (folded or unfolded) to the intermediate state, so that the electronic device 100 is in the intermediate state.

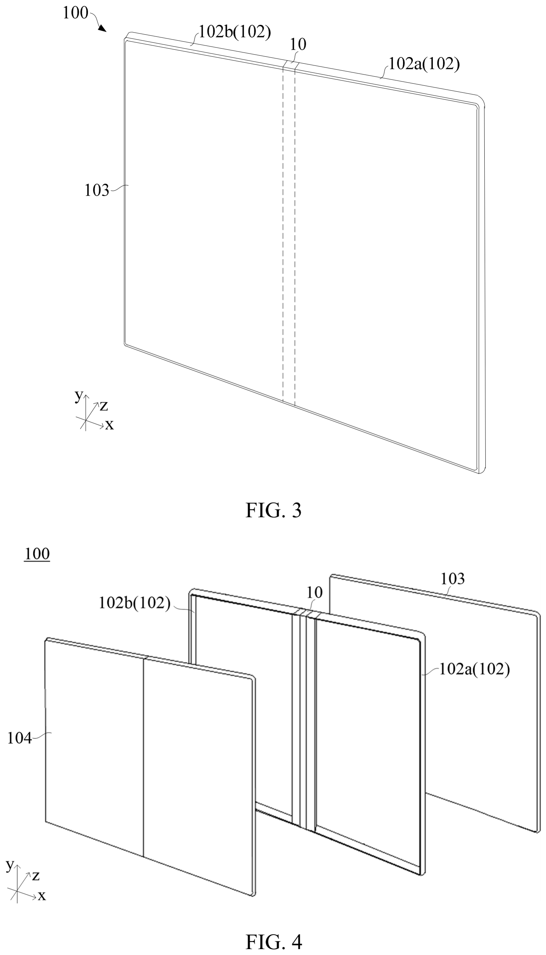

FIG. 3 is a diagram of a structure of the foldable electronic device shown in FIG. 1 in an unfolded state.

As shown in FIG. 3, the first middle frame 102a and the second middle frame 102b can be unfolded relative to each other to an open state. For example, the first middle frame 102a and the second middle frame 102b are in the open state, an unfolded angle between the first middle frame 102a and the hinge 10, and an unfolded angle between the hinge 10 and the second middle frame 102b may be approximately 180°, and the electronic device 100 is in the open state as a whole, which is also referred to as an unfolded state.

It should be noted that a slight deviation is allowed in the angle described in the example in embodiments of this application. For example, an unfolded angle of the foldable electronic device 100 shown in FIG. 3 may be 180°, or may be approximately 180°, for example, 170°, 175°, 185°, or 190°. An angle described in the following example can be understood in a same way.

The intermediate state shown in FIG. 2 may be any state between the folded state and the unfolded state. That is, the electronic device 100 may switch between the unfolded state (that is, the open state) and the folded state (that is, the closed state) by moving the hinge 10, to implement unfolding and folding of the electronic device 100.

For example, when the electronic device 100 is in the unfolded state, the first middle frame 102a and the second middle frame 102b rotate toward each other and are folded relative to each other, so that the electronic device 100 can switch from the unfolded state to the folded state (or intermediate state). When the electronic device 100 is in the folded state, the first middle frame 102a and the second middle frame 102b rotate away from each other and are unfolded relative to each other, so that the electronic device 100 can switch from the folded state to the unfolded state (or intermediate state).

For example, the middle frame 102 may be of a rectangular flat plate-shaped structure. In embodiments of this application, as shown in FIG. 3, a width direction of the middle frame 102 (for example, the first middle frame 102a) is an x direction, a length direction of the middle frame 102 is a y direction, and a thickness direction of the middle frame 102 is a z direction. It may be understood that a length direction of the hinge 10 may be an axial direction of the hinge, that is, an extension direction of the hinge. The length direction, a width direction, and a thickness direction of the hinge 10 may be respectively consistent with the length direction, the width direction, and the thickness direction of the middle frame 102.

It may be understood that the length, the width, and the thickness in embodiments of this application are merely for ease of description, and do not mean any limitation on a size. For example, the length may be greater than, equal to, or less than the width. It may be understood that, when the foldable electronic device 100 is in the folded state or the unfolded state, a length direction, a width direction, and a thickness direction of the electronic device 100 may be correspondingly consistent with the length direction, the width direction, and the thickness direction of the middle frame 102.

Certainly, in some other examples, the middle frame 102 may alternatively be of a flat plate-shaped structure in a shape like a square, a circle, an ellipse, or a rounded rectangle.

It should be noted that the electronic device 100 may include only two middle frames 102. For example, there may be one first middle frame 102a and one second middle frame 102b, so that the first middle frame 102a and the second middle frame 102b are folded relative to each other into two layers when the electronic device 100 is in the folded state. For example, as shown in FIG. 1, the electronic device 100 includes one first middle frame 102a, one second middle frame 102b, and one hinge 10. The first middle frame 102a and the second middle frame 102b are rotatably connected through the hinge 10. When the first middle frame 102a and the second middle frame 102b are folded relative to each other to be in a folded state, the electronic device 100 is in a form of two layers of middle frames stacked.

Alternatively, the electronic device 100 may include a plurality of middle frames 102. There may be a plurality of first middle frames 102a, a plurality of second middle frames 102b, and a plurality of hinges 10. A first middle frame 102a and a second middle frame 102b that are adjacent to each other may be connected through one hinge 10, so that the electronic device 100 may be folded into a form of a plurality of layers. For example, the electronic device 100 may include two first middle frames 102a, one second middle frame 102b, and two hinges 10. The two first middle frames 102a are located on two sides of the second middle frame 102b, and the two first middle frames 102a are rotatively connected to the second middle frame 102b through one hinge 10. One of the first middle frames 102a may be folded relative to the second middle frame 102b, and the other first middle frame 102a may also be folded relative to the second middle frame 102b, so that the first middle frames 102a and the second middle frame 102b are folded in a form of three layers of middle frames stacked when the electronic device 100 is in a folded state. When one of the first middle frames 102a and the second middle frame 102b are unfolded relative to each other to an unfolded state, the electronic device 100 is in an unfolded state.

In embodiments of this application, an example in which the electronic device 100 includes two middle frames: the first middle frame 102a and the second middle frame 102b, and the first middle frame 102a and the second middle frame 102b implement a rotatable fit through one hinge 10 is used for description.

As shown in FIG. 3, the electronic device 100 may further include a foldable flexible display 103. The flexible display 103 is used as a display of the electronic device 100, and is configured to display an image, a text, a video, and the like.

The flexible display 103 is laid on the hinge 10 and the middle frame 102. For example, the flexible display 103 may be attached to the first middle frame 102a and the second middle frame 102b, and the flexible display 103 may be located on a same side surface of the first middle frame 102a, the second middle frame 102b, and the hinge 10. When the first middle frame 102a and the second middle frame 102b are folded relative to each other, a part of the flexible display 103 corresponding to the hinge 10 is bent. When the first middle frame 102a and the second middle frame 102b are unfolded relative to each other, the hinge 10 and the bent part of the flexible display 103 are also unfolded accordingly.

For example, for a foldable electronic device with a screen that folds outward, the flexible display 103 may be disposed on outer surfaces of the first middle frame 102a, the second middle frame 102b, and the hinge 10. For a foldable electronic device with a screen that folds inward, the flexible display 103 may be disposed on inner surfaces of the first middle frame 102a, the second middle frame 102b, and the hinge 10.

It may be understood that, in some other examples, for example, in the foregoing foldable electronic device with three middle frames, the flexible display 103 is disposed on the two first middle frames 102a, one second middle frame 102b, and the hinges 10. A part of the flexible display 103 may be located on inner surfaces of one of the first middle frames 102a, one of the hinges 10, and the second middle frame 102b, and a part of the flexible display 103 may be located on an outer surface of the other first middle frame 102a. Alternatively, in some examples, the flexible display 103 may be located on inner surfaces of the two first middle frames 102a, one second middle frame 102b, and the hinges 10.

For example, when the electronic device 100 is in a folded state, two adjacent and opposite surfaces of the first middle frame 102a and the second middle frame 102b may be inner surfaces of the first middle frame 102a and the second middle frame 102b respectively, and a surface that is of the hinge 10 and that is located on a same side as the inner surfaces of the first middle frame 102a and the second middle frame 102b is an inner surface of the hinge 10. Two opposite surfaces of the first middle frame 102a and the second middle frame 102b are outer surfaces of the first middle frame 102a and the second middle frame 102b respectively, and a surface that is of the hinge 10 and that is located on a same side as the outer surfaces of the first middle frame 102a and the second middle frame 102b is an outer surface of the hinge 10.

FIG. 4 is a schematic exploded view of a structure of the foldable electronic device shown in FIG. 1.

As shown in FIG. 4, the electronic device 100 may further include a rear cover 104. The flexible display 103 and the rear cover 104 may be respectively located on two opposite sides of the two middle frames 102 and the hinge 10 in the thickness direction (z direction). The rear cover 104, the flexible display 103, and the middle frames 102 jointly form an accommodating cavity, and the accommodating cavity may be used to assemble and accommodate functional components of the electronic device 100.

The rear cover 104 may be used as an appearance cover at the back of the electronic device 100, to protect the internal components (for example, a circuit board and a battery) inside the electronic device 100 and improve aesthetics of the electronic device 100.

The electronic device 100 may further include a circuit board, a battery, a charging management module, a power management module, and the like (not shown in the figure). The circuit board, the battery, the charging management module, the power management module, and the like may be fastened in the accommodating cavity.

The circuit board may include a processor. The processor may include an application processor (application processor, AP for short), a modem processor, a graphics processing unit (graphics processing unit, GPU for short), an image signal processor (image signal processor, ISP for short), a controller, a video codec, a digital signal processor (digital signal processor, DSP for short), a baseband processor, a display processing unit (display processing unit, DPU for short), a neural-network processing unit (neural-network processing unit, NPU for short), and/or the like. The controller may be a neural center and a command center of the electronic device 100. The controller may generate an operation control signal based on an instruction operation code and a time sequence signal, to complete control of instruction reading and instruction execution. A memory may be further disposed in the processor, and is configured to store instructions and data. The processor may include one or more interfaces. The interface may be configured to connect to a charger to charge the electronic device 100. The interface may also be configured to implement data transmission between the electronic device 100 and an external device, for example, may also be configured to connect to a headset, a projection apparatus, or the like.

The charging management module is configured to receive a charging input from the charger. The charger may be a wireless charger or a wired charger. In some examples of wired charging, the charging management module may receive a charging input of a wired charger through a port. In some embodiments of wireless charging, the charging management module may receive a wireless charging input through a wireless charging coil of the electronic device 100. The charging management module can charge the battery, and may further supply power to the electronic device 100 by using the power management module.

The power management module is configured to connect to the battery, the charging management module, and the processor. The power management module receives an input of the battery and/or the charging management module, to supply power to the processor, the memory, the foldable display, a camera module, and the like. The power management module may be configured to monitor parameters such as a battery capacity, a battery cycle count, and a battery health status (electric leakage or impedance).

In some examples, the power management module may be disposed in the processor of the circuit board. In some other examples, the power management module and the charging management module may alternatively be disposed in a same device.

The structure shown in embodiments of this application does not constitute a specific limitation on the electronic device 100. In some other embodiments of this application, the electronic device 100 may include more or fewer components than those shown in the figure, or some components may be combined, or some components may be split, or different component arrangements may be used. For example, the electronic device 100 may further include components such as a communication module, the camera module (for example, a front-facing camera and a rear-facing camera), a microphone, a speaker, and a flash.

The first middle frame 102a, a part of the rear cover 104, and a part of the flexible display 103 may form an accommodating cavity, and the second middle frame 102b, a part of the rear cover 104, and a part of the flexible display 103 may form another accommodating cavity, which may all be configured to accommodate the foregoing electronic components such as the processor, the flash, the microphone, the sensor, the camera module, the battery, the power management module, and the charging management module.

The electronic device further includes a flexible circuit board, and the flexible circuit board is configured to implement an electrical connection between electronic components inside the electronic device. The flexible circuit board passes through the hinge, so that one end of the flexible circuit board may be located in the accommodating cavity formed by the first middle frame, and the other end of the flexible circuit board may be located in the accommodating cavity formed by the second middle frame, to implement the electrical connection between the electronic components in the two middle frames.

It may be understood that the end of the flexible circuit board may be fastened in the first middle frame, and the other end of the flexible circuit board may also be fastened in the second middle frame. When the first middle frame and the second middle frame rotate relative to each other to fold or unfold, the flexible circuit board may bend as the first middle frame and the second middle frame rotate.

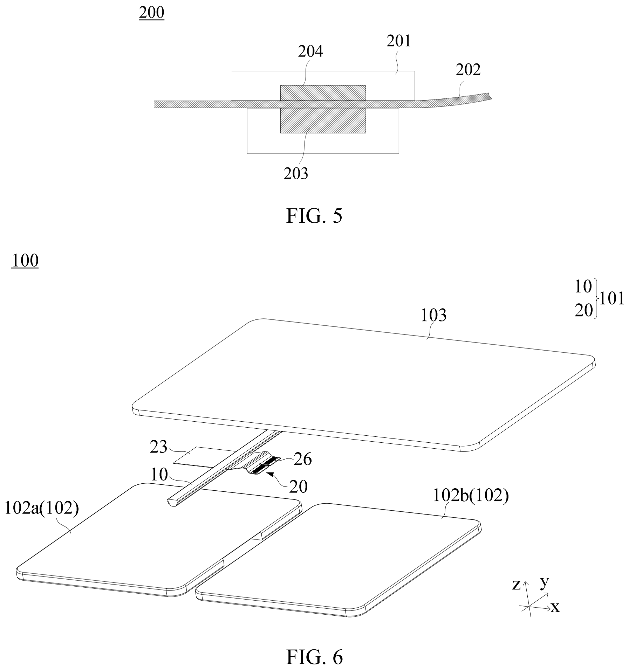

FIG. 5 is a diagram of assembling a flexible circuit board and a hinge in an electronic device in a related technology.

To implement assembly and fastening between the flexible circuit board and the hinge, the flexible circuit board and the hinge are usually limited and fastened in a magnetic attraction manner. For example, as shown in FIG. 5, the hinge assembly 200 may include a hinge 201, a flexible circuit board 202, a first magnet 203, and a second magnet 204. The first magnet 203 is fastened to one surface of the flexible circuit board 202, the second magnet 204 is fastened in the hinge 201, and one end of the flexible circuit board 202 passes through the hinge 201, the first magnet 203 and the second magnet 204 are located on two opposite sides of the flexible circuit board 202, and one end that is of the first magnet 203 and that faces the flexible circuit board 202 and one end that is of the second magnet 204 and that faces the flexible circuit board 202 attract each other, so that the first magnet 203 and the second magnet 204 can be attached together, so that the flexible circuit board 202 and the hinge 201 are fastened.

However, the flexible circuit board 202 is located between the first magnet 203 and the second magnet 204. To ensure firmness of assembly between the flexible circuit board 202 and the hinge 201, the first magnet 203 and the second magnet 204 need to have large thicknesses, to improve magnetic attraction force. In this way, larger space is required in the hinge 201 to accommodate the two magnets. As a result, strength of the hinge 201 is reduced, and a risk of breakage of the hinge 201 is increased in scenarios such as drop and impact. In addition, relying only on magnetic attraction of the magnets to limit the flexible circuit board 202 to the hinge 201 provides low limiting firmness and reliability. In scenarios such as drop and impact, the flexible circuit board 202 is prone to moving, falling off, and the like, causing poor reliability, and increasing a risk of breakage of the hinge 201.

Based on this, an embodiment of this application provides a hinge assembly, including a hinge, a flexible circuit board, a snap-fit member located on the flexible circuit board, and a first attachment member. When the flexible circuit board passes through the hinge through a through hole, the first attachment member may be located in the through hole and is attached to a second attachment member in the hinge, to implement limiting and fastening of the flexible circuit board. For example, movement of the flexible circuit board relative to the hinge in a thickness direction can be limited, and displacement of the flexible circuit board in the thickness direction in scenarios such as daily use or drop is limited, so that the flexible circuit board and the hinge are assembled. In addition, the first attachment member and the second attachment member are located on a same side of the flexible circuit board, and a total thickness of the two attachment members can be reduced while a high attachment force is ensured, to reduce thickness space occupied in the hinge, and improve strength of the hinge, thereby reducing a risk of breakage of the hinge in scenarios such as drop and impact, and improving a service life and use experience.

Alternatively, the snap-fit member may be inserted into the through hole and be in a snap-fit with the hinge, to implement limiting and fastening of the flexible circuit board. For example, movement of the flexible circuit board relative to the hinge in a length direction and a width direction may be limited, and displacement of the flexible circuit board in the length direction and the width direction in scenarios such as daily use or drop is limited, to further improve limiting firmness of the flexible circuit board and the hinge, thereby reducing or avoiding phenomena such as movement, falling off, or the like of the flexible circuit board in scenarios such as drop and impact, and reducing a risk of breakage of the hinge caused by collision between the hinge and the flexible circuit board or the first attachment member. In addition, ease of detachment of the flexible circuit board from the hinge can be implemented, facilitating disassembly in scenarios such as repair.

FIG. 6 is a schematic exploded view of a partial structure of a foldable electronic device according to an embodiment of this application.

As shown in FIG. 6, a hinge assembly 101 includes a flexible circuit board assembly 20 and a hinge 10, the flexible circuit board assembly 20 includes a flexible circuit board 23, the flexible circuit board 23 passes through the hinge 10, and a first middle frame 102a and a second middle frame 102b are respectively located on two sides of the hinge 10.

A pass-through direction of the flexible circuit board 23 may intersect with a thickness direction of the hinge 10 and a length direction of the hinge 10, that is, there may be a non-zero included angle between the pass-through direction and the thickness direction, and between the pass-through direction and the length direction.

For example, the pass-through direction of the flexible circuit board 23 may be separately perpendicular to the thickness direction and the length direction of the hinge 10, that is, the pass-through direction may be parallel to the width direction (x direction). In other words, one end of the flexible circuit board 23 may pass through the hinge 10 in the x direction, so that one end of the flexible circuit board 23 may be disposed in the second middle frame 102b, the other end of the flexible circuit board 23 may be disposed in the second middle frame 102b, and a part of the flexible circuit board 23 is disposed in the hinge 10.

Certainly, in some examples, the pass-through direction of the flexible circuit board 23 may not be parallel to the width direction, and the pass-through direction may intersect with the width direction, that is, there may be a non-zero included angle between the pass-through direction and the width direction. In embodiments of this application, an example in which the pass-through direction of the flexible circuit board 23 is separately perpendicular to the length direction and the thickness direction of the hinge 10, and the pass-through direction is parallel to the width direction is used for description.

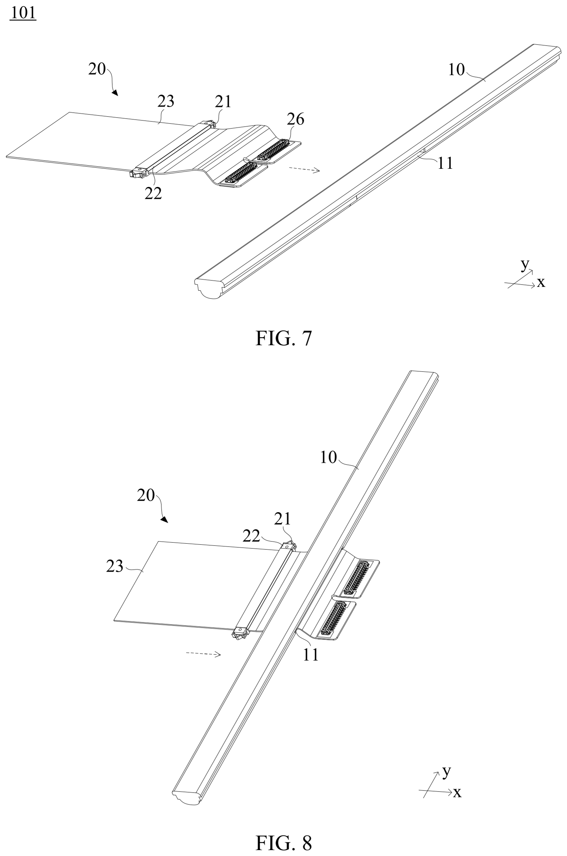

FIG. 7 is a schematic exploded view of a structure of the hinge assembly in FIG. 6.

With reference to FIG. 7, for example, a through hole 11 may be provided on the hinge 10, the through hole 11 may penetrate the hinge 10 in the width direction (that is, the pass-through direction, for example, the x direction in the figure), and the flexible circuit board 23 may pass through the hinge 10 through the through hole 11.

In some examples, as shown in FIG. 7, the flexible circuit board assembly 20 may further include an electrical connection component 26. The electrical connection component 26 may be a structure that can connect two active devices. The electrical connection component 26 may be disposed on the flexible circuit board 23, and the flexible circuit board 23 may be electrically connected to an electronic component in the middle frame through the electrical connection component 26. For example, an electrical connection component 26 may be disposed at one end of the flexible circuit board 23, and the electrical connection component 26 may be a board-to-board connector (board-to-board connector, BTB for short), or the like.

Still refer to FIG. 7. The flexible circuit assembly further includes a snap-fit member 21 and a first attachment member 22. The snap-fit member 21 and the first attachment member 22 are disposed on the flexible circuit board 23. The snap-fit member 21 and the first attachment member 22 are configured to limit and fasten the flexible circuit board 23 to the hinge 10 when the flexible circuit board 23 passes through the hinge 10, so that the flexible circuit board 23 and the hinge 10 are assembled and fastened together.

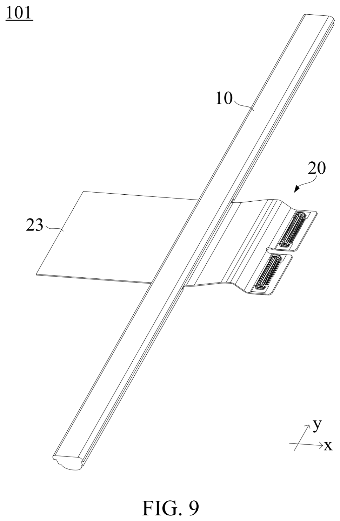

FIG. 8 is a diagram of a process state of assembling a flexible circuit board assembly and a hinge in the hinge assembly in FIG. 7, and FIG. 9 is a diagram of a structure obtained after a flexible circuit board and a hinge in the hinge assembly in FIG. 7 are assembled.

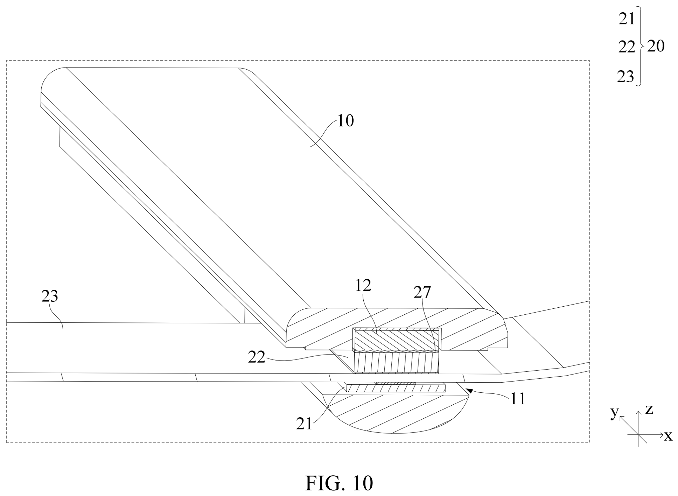

As shown in FIG. 8, to implement pass-through of the flexible circuit board 23 in the hinge 10, one end of the flexible circuit board 23 may be pulled to enable a flexible circuit to pass through the through hole 11 on the hinge 10 in a pass-through direction (the x direction in the figure). The snap-fit member 21 and the first attachment member 22 on the flexible circuit board 23 may move in the pass-through direction of the flexible circuit board 23 and enter the through hole 11. With reference to FIG. 9, when the flexible circuit board 23 passes through the hinge 10 through the through hole 11, the snap-fit member (not shown in the figure) and the first attachment member (not shown in the figure) are disposed in the through hole 11 of the hinge 10 (as shown in FIG. 10), and are cooperatively connected to the hinge 10 or a mechanical part in the hinge 10.

FIG. 10 is a schematic sectional view of the structure of the hinge assembly in FIG. 9 along an A-A plane.

As shown in FIG. 10, a second attachment member 12 is disposed in the hinge 10. The first attachment member 22 and the second attachment member 12 may be two mechanical parts that can be attached. For example, the first attachment member 22 and the second attachment member 12 may be magnetic attraction members respectively. For example, the first attachment member 22 and the second attachment member 12 may be magnets respectively. The first attachment member 22 may have two magnetic poles, for example, an N pole and an S pole respectively. The second attachment member 12 may also have two magnetic poles, for example, an N pole and an S pole respectively. Magnetic attraction cooperation may occur between two magnetic poles of the first attachment member 22 and the second attachment member 12 with opposite polarities.

For example, when the N pole of the first attachment member 22 is close to or abuts against the S pole of the second attachment member 12, magnetic attraction cooperation may be performed, to implement an attachment between the first attachment member 22 and the second attachment member 12. Alternatively, when the S pole of the first attachment member 22 is close to or abuts against the N pole of the second attachment member 12, magnetic attraction cooperation may be performed, to implement an attachment between the first attachment member 22 and the second attachment member 12.

When the flexible circuit board 23 passes through the hinge 10 through the through hole 11, the first attachment member 22 may enter the through hole 11 and be attached to the second attachment member 12 in the through hole 11. Specifically, one end that is of the first attachment member 22 and that faces away from the flexible circuit board 23 in the thickness direction (z direction) is attached to the second attachment member 12. For example, one end that is of the first attachment member 22 that faces away from the flexible circuit board 23 in the thickness direction has polarity opposite to that of one end that is of the second attachment member 12 and that faces the end of the first attachment member 22, so that the first attachment member 22 and the second attachment member 12 can be connected together through magnetic attraction cooperation.

The attachment between the first attachment member 22 and the second attachment member 12 may implement limiting and fastening of the flexible circuit board 23. For example, movement of the flexible circuit board 23 relative to the hinge 10 in the thickness direction may be limited, and displacement of the flexible circuit board 23 in the thickness direction in scenarios such as daily use or drop is limited, so that the flexible circuit board 23 and the hinge 10 are assembled and fastened.

It may be understood that the attachment between the first attachment member 22 and the second attachment member 12 may be separated under a specific external force. For example, when an external force is greater than an attachment force between the first attachment member 22 and the second attachment member 12, the first attachment member 22 and the second attachment member 12 are separated under the external force.

The end that is of the first attachment member 22 and that faces away from the flexible circuit board 23 is attached to the second attachment member 12. To be specific, as shown in FIG. 10, in the thickness direction, the second attachment member 12 may be located on a side that is of the first attachment member 22 and that faces away from the flexible circuit board 23, and the first attachment member 22 and the second attachment member 12 are located on a same side of the flexible circuit board 23. While a high attachment force between the first attachment member 22 and the second attachment member 12 is ensured to meet firmness of limiting of the flexible circuit board 23 to the hinge 10, thicknesses of the first attachment member 22 and the second attachment member 12 can be reduced, that is, thickness space occupied in the hinge 10 can be reduced, and strength of the hinge 10 can be improved, thereby reducing a risk of breakage of the hinge 10 in scenarios such as drop and impact, and further improving a service life and use experience.

Still refer to FIG. 10. For example, to protect the first attachment member 22 and the second attachment member 12, a thin film 27 may be disposed between the first attachment member 22 and the second attachment member. For example, the thin film 27 may be a plastic (polyethylene terephthalate, PET for short) film. The thin film 27 can reduce or avoid friction damage caused to the first attachment member 22 and/or the second attachment member 12 in a process in which the first attachment member 22 enters the through hole 11 in the pass-through direction and is attached to the second attachment member 12.

The thin film 27 may be fastened to the first attachment member 22, or the thin film 27 may be fastened to the second attachment member 12, or the thin film 27 may be disposed on each of the first attachment member 22 and the second attachment member 12.

The snap-fit member 21 may be inserted into the through hole 11 in the pass-through direction of the flexible circuit board 23, and is in a snap-fit with the hinge 10. In other words, the snap-fit member 21 is detachably connected to the hinge 10 via the snap-fit.

When the flexible circuit board 23 passes through the hinge 10 through the through hole 11, the snap-fit member 21 may be inserted into the through hole 11 in the pass-through direction of the flexible circuit board 23 (as shown in FIG. 8 and FIG. 9), and the snap-fit member 21 may be in the snap-fit with the hinge 10, so that the flexible circuit board 23 may be in a snap-fit connection to the hinge 10 through the snap-fit member 21, to implement limiting and fastening of the flexible circuit board 23. For example, movement of the flexible circuit board 23 relative to the hinge 10 in the length direction and the width direction may be limited, and displacement of the flexible circuit board 23 in the length direction and the width direction in scenarios such as daily use or drop is limited, thereby further improving firmness of limiting of the flexible circuit board 23 to the hinge 10, and improving assembly stability and reliability of the flexible circuit board 23. Phenomena such as movement, falling off, or the like of the flexible circuit board 23 in scenarios such as drop and impact are reduced or avoided, and a risk of breakage of the hinge 10 caused by collision between the hinge 10 and the flexible circuit board 23 or the first attachment member 22 can also be reduced, thereby further improving a service life and use experience.

The snap-fit member 21 can also be detached from the hinge 10, and the first attachment member 22 and the second attachment member 12 can also be detached under an action of a specific external force. For example, the other end of the flexible circuit board 23 is pulled backward, to cause the snap-fit member 21 to be detached from the hinge 10, and the first attachment member 22 to be detached from the second attachment member 12, so that the flexible circuit board 23 can be detached from the hinge 10, thereby significantly improving ease of detachment of the flexible circuit board 23, and facilitating disassembly in scenarios such as repair.

To be specific, in a scenario of assembling the flexible circuit board assembly 20 and the hinge 10, one end of the flexible circuit is pulled to pass through the through hole 11 on the hinge 10. In this case, the flexible circuit board 23 passes through the hinge 10, and the snap-fit member 21 and the first attachment member 22 enter the through hole 11, so that the snap-fit member 21 and the hinge 10 are in the snap-fit, and the first attachment member 22 is attached to the second attachment member 12. In this way, the flexible circuit board 23 and the hinge 10 are assembled and fastened, and the assembly operation is simple and easy to implement.

In scenarios such as disassembly and repair of the flexible circuit board assembly 20, the other end of the flexible circuit board 23 may be pulled backward, so that the snap-fit member 21 is separated from the hinge 10, the first attachment member 22 is separated from the second attachment member 12, and the flexible circuit board 23 is pulled out of the through hole 11 of the hinge 10, to complete detachment of the flexible circuit board 23.

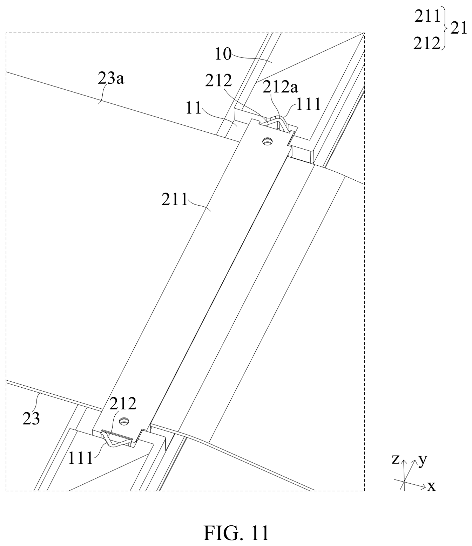

FIG. 11 is a schematic sectional view of the structure of the hinge assembly in FIG. 9 along a B-B plane.

To implement the snap-fit between the snap-fit member 21 and the hinge 10, for example, as shown in FIG. 11, the snap-fit member 21 may include a first main body part 211, and the first main body part 211 may be used as a main mechanical part for assembly and fastening of the flexible circuit board 23 and the snap-fit member 21. For example, the first main body part 211 of the snap-fit member 21 may be attached and fastened to a first surface 23a of the flexible circuit board 23, to implement assembly and fastening of the snap-fit member 21 and the flexible circuit board 23.

The snap-fit member 21 may further include a first snap-fit part 212. For example, the first snap-fit part 212 may be disposed on each of end parts of two opposite ends of the first main body part 211 in the length direction (y direction). A second snap-fit part 111 may be disposed on the hinge 10. For example, the second snap-fit part 111 may be disposed on each of two opposite inner side walls of the through hole 11 in the length direction.

The first snap-fit part 212 and the second snap-fit part 111 may be in a snap-fit, to ensure that limiting and fastening to the hinge 10 can be implemented via the snap-fit between the first snap-fit part 212 and the second snap-fit part 111 when the snap-fit member 21 is inserted into the through hole 11 in the width direction (x direction), and movement of the snap-fit member 21 and the flexible circuit board 23 relative to the hinge 10 on an x-y plane is limited.

The first snap-fit part 212 and the second snap-fit part 111 may be mechanical parts that can implement the snap-fit. For example, the first snap-fit part 212 and the second snap-fit part 111 may be a fastener and a snap-fit slot respectively. Alternatively, one of the first snap-fit part 212 and the second snap-fit part 111 may be an elastic snap-fit plate, and the snap-fit plate may be provided with a recessed groove. The other one may be a protrusion, and the protrusion part may be in a snap-fit with the recessed groove on the elastic card.

Alternatively, one of the first snap-fit part 212 and the second snap-fit part 111 may include an elastic protrusion 212a, and the other one may be a recessed groove that can be in a snap-fit with the elastic protrusion 212a.

Still refer to FIG. 11, for example, the first snap-fit part 212 on the snap-fit member 21 includes an elastic protrusion 212a, and the second snap-fit part 111 on the inner side wall of the through hole 11 of the hinge 10 is a recessed groove. When the snap-fit member 21 moves in the pass-through direction (the width direction, that is, the x direction) and is inserted into the through hole 11, the elastic protrusion 212a may be pressed by the inner side wall of the through hole 11, that is, the elastic protrusion 212a is pressed in a direction toward the first main body part 211.

The flexible circuit board 23 is continuously pulled for insertion of the snap-fit member 21, the elastic protrusion 212a moves to a position of the recessed groove, and the elastic protrusion 212a is restored under a rebound action, that is, the elastic protrusion 212a moves away from the first main body part 211, so that the elastic protrusion 212a is accommodated in and in the snap-fit with the recessed groove. In this way, the snap-fit member 21 can be connected to and assembled with the hinge 10 via a fit between the elastic protrusion 212a and the recessed groove.

In scenarios such as detaching the flexible circuit board 23, the flexible circuit board 23 is pulled backward, so that the snap-fit member 21 moves backward, and the elastic protrusion 212a may be pressed again. In this way, the flexible circuit board 23 can be detached from the hinge 10. The structure design is simple, and facilitates production implementation.

The first snap-fit part 212 includes the elastic protrusion 212a, and the second snap-fit part 111 is the recessed groove. This helps simplify a design of an internal structure of the through hole 11 of the hinge 10, and reduce difficulty in designing and forming the hinge 10, and also helps ensure strength of the hinge 10, thereby facilitating implementation.

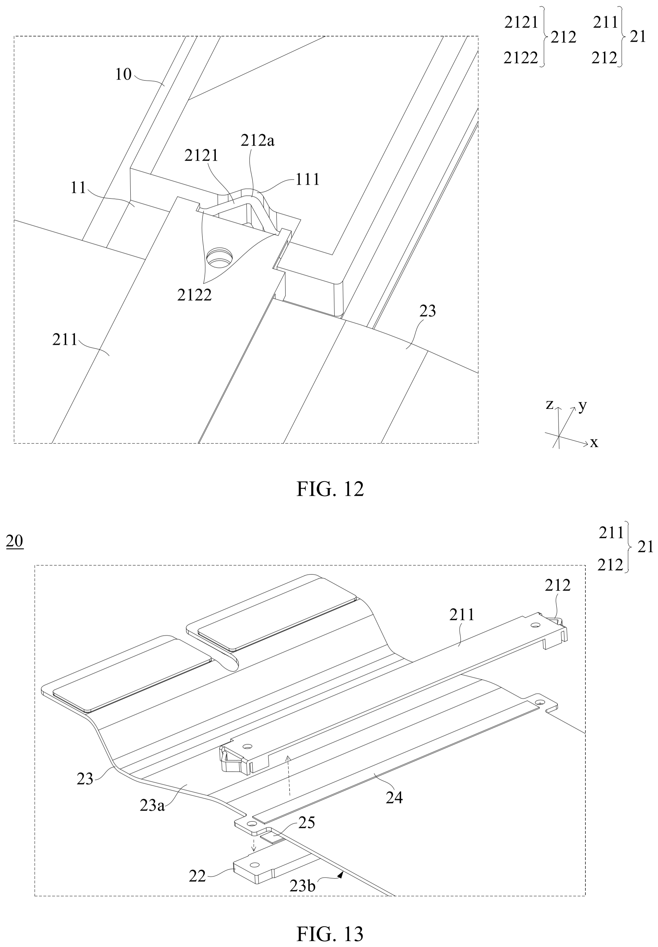

FIG. 12 is a schematic locally enlarged view of a structure at a fitting part of the first snap-fit part and the second snap-fit part in FIG. 11.

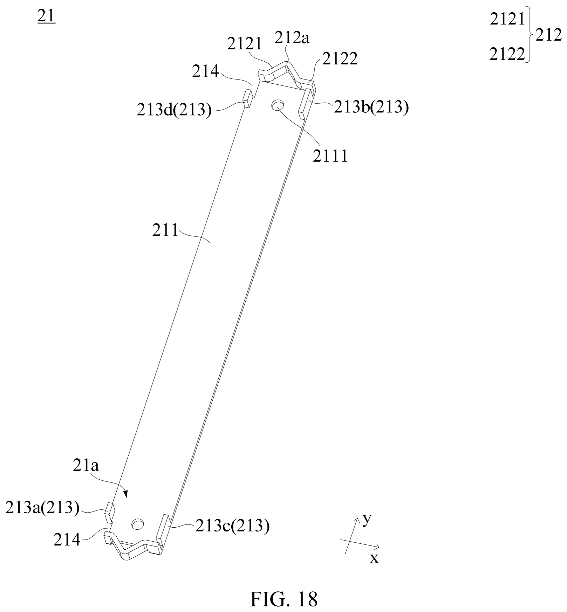

For example, as shown in FIG. 12, the first snap-fit part 212 may include a snap-fit arm 2121 and a connecting arm 2122, the snap-fit arm 2121 is connected to the connecting arm 2122, and the connecting arm 2122 is connected to the first main body part 211 (as shown in FIG. 18), so that the first snap-fit part 212 and the first main body part 211 are fastened together.

There may be two connecting arms 2122. The two connecting arms 2122 may be respectively located on two sides of the snap-fit arm 2121 in the pass-through direction. Two end parts of the snap-fit arm 2121 may be respectively connected to the two connecting arms 2122, and a middle part of the snap-fit arm 2121 may protrude (for example, protrude to the other first snap-fit part 212 in the length direction) to form the foregoing elastic protrusion 212a. It should be noted that the middle part of the snap-fit arm 2121 may be a part between the two end parts of the snap-fit arm 2121.

The part of the snap-fit arm 2121 forms the elastic protrusion 212a to implement a snap-fit with the recessed groove on the hinge 10, and the two end parts of the snap-fit arm 2121 are both connected to the first main body part 211 through the connecting arms 2122, which helps improve strength of the snap-fit arm 2121, and further improve firmness of the snap-fit between the elastic protrusion 212a of the snap-fit arm 2121 and the recessed groove on the hinge 10. This improves reliability and stability of the snap-fit between the snap-fit member 21 and the hinge 10, and helps reduce phenomena such as movement or falling off of the flexible circuit board 23 in scenarios such as drop.

A shape of an outer surface of the elastic protrusion 212a may conform to a shape of an inner surface of the recessed groove. For example, the outer surface of the elastic protrusion 212a may be an arc-shaped surface, and the inner surface of the recessed groove may also be an arc-shaped surface, so that the elastic protrusion 212a is accommodated in and in the snap-fit with the recessed groove when the snap-fit member 21 moves in the pass-through direction, to implement the snap-fit between the elastic protrusion 212a and the recessed groove. This helps improve ease of assembly. Correspondingly, the elastic protrusion 212a can be easily removed out of the recessed groove in a scenario of detaching the flexible circuit board, thereby reducing a difficulty in detaching the flexible circuit board.

It may be understood that, during assembly of the flexible circuit board assembly 20, when the first snap-fit part 212 of the snap-fit member 21 is in the snap-fit with the second snap-fit part 111 of the hinge 10, the first attachment member 22 and the second attachment member 12 implement an attachment fit, to ensure high assembly firmness of the flexible circuit board assembly 20. For example, when the elastic protrusion 212a of the snap-fit member 21 is accommodated in and in the snap-fit with the recessed groove on the hinge 10, a position of the first attachment member 22 may correspond to that of the second attachment member 12 in the thickness direction. For example, projections of the first attachment member 22 and the second attachment member 12 in the thickness direction overlap, to ensure strong attachment between the first attachment member 22 and the second attachment member 12.

It should be noted that the snap-fit member 21 may be disposed on one side surface of the flexible circuit board 23, and at least a part of the snap-fit member 21 may be fastened on the side surface of the flexible circuit board 23. For example, the first main body part 211 of the snap-fit member 21 may be fastened on the side surface of the flexible circuit board 23. Alternatively, the entire snap-fit member 21 may be fastened on the side surface of the flexible circuit board 23.

In some examples, the at least part of the snap-fit member 21 and the first attachment member 22 may be disposed on a same side surface of the flexible circuit board 23. For example, the first main body part 211 of the snap-fit member 21 and the first attachment member 22 may be sequentially arranged on one side of the flexible circuit board 23 in the pass-through direction. When the snap-fit member 21 is in the snap-fit with the hinge 10, the first attachment member 22 is attached to the second attachment member 12.

Alternatively, the at least part of the snap-fit member 21 and the first attachment member 22 may be respectively disposed on two opposite side surfaces of the flexible circuit board 23. For example, the first main body part 211 of the snap-fit member 21 and the first attachment member 22 may be respectively located on two sides of the flexible circuit board 23 in the thickness direction.

FIG. 13 is a schematic exploded view of a partial structure of the flexible circuit board assembly in FIG. 7.

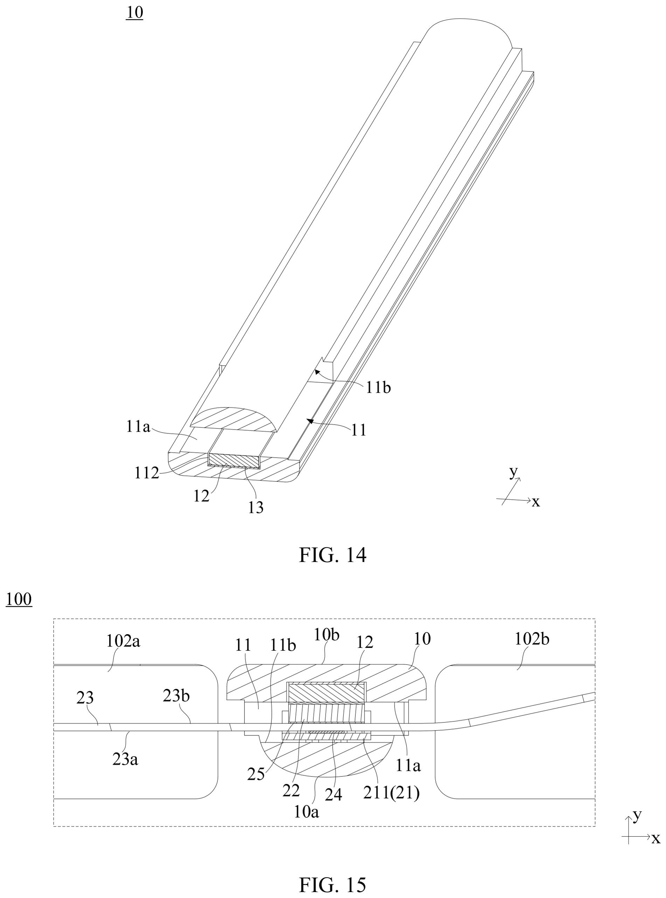

For example, as shown in FIG. 13, the flexible circuit board 23 may include a first surface 23a and a second surface 23b. The first surface 23a and the second surface 23b may be opposite to each other in the thickness direction of the flexible circuit board 23. The first main body part 211 of the snap-fit member 21 may be located on the first surface 23a of the flexible circuit board 23, and the first attachment member 22 may be located on the second surface 23b of the flexible circuit board 23 (as shown in FIG. 15). In this case, the first main body part 211, a part of the flexible circuit board 23, and the first attachment member 22 may be sequentially stacked in the thickness direction (as shown in FIG. 10), the first main body part 211, the part of flexible circuit board 23, and the first attachment member 22 may form a stacked structure, and vertical projections of the first main body part 211, the flexible circuit board 23, and the first attachment member 22 in the thickness direction at least partially overlap.

Still as shown in FIG. 13, the flexible circuit board assembly 20 may further include a first bonding layer 24 and a second bonding layer 25, and both the first bonding layer 24 and the second bonding layer 25 may be adhesive layers. The snap-fit member 21 may be bonded and fastened to the flexible circuit board 23 through the first bonding layer 24.

For example, the first bonding layer 24 may be located between the first main body part 211 of the snap-fit member 21 and the first surface 23a of the flexible circuit board 23, so that the first main body part 211 is bonded and fastened to the first surface 23a of the flexible circuit board 23 through the first bonding layer 24, to implement fastening between the snap-fit member 21 and the flexible circuit board 23.

The second bonding layer 25 may be located between the first attachment member 22 and the second surface 23b of the flexible circuit board 23, and the first attachment member 22 may be bonded and fastened to the second surface 23b of the flexible circuit board 23 through the second bonding layer 25.

FIG. 14 is a schematic sectional view of a structure of the hinge in the hinge assembly in FIG. 9. As shown in FIG. 14, the hinge assembly may include a third bonding layer 13, the third bonding layer 13 is located between the hinge 10 and the second attachment member 12, and the second attachment member 12 may be fastened in the hinge 10 through the third bonding layer 13.

For example, the second attachment member 12 may be located on an inner side wall of the through hole 11 in the thickness direction, that is, the through hole 11 may include two opposite inner walls in the thickness direction, and the second attachment member 12 may be fastened to one of the inner walls. As shown in FIG. 14, the through hole 11 may include an inner wall 11a and an inner wall 11b (as shown in FIG. 15) that are opposite in the thickness direction, and the second attachment member 12 may be fastened to the inner wall 11a of the through hole 11.

For example, the inner wall 11a of the through hole 11 may be provided with a mounting groove 112. The third bonding layer 13 may be located between a groove bottom of the mounting groove 112 and the second attachment member 12, so that the second attachment member 12 may be fastened in the mounting groove 112 through the third bonding layer 13. The mounting groove 112 may be provided to improve firmness of fastening of the second attachment member 12 to the hinge 10, thereby helping improve firmness of fastening and limiting of the flexible circuit board assembly 20 to the hinge 10.

Certainly, in some examples, the inner wall of the through hole 11 may be provided with no mounting groove 112. For example, the second attachment member 12 may be fastened, through the third bonding layer 13, to one of surfaces of two opposite inner walls in the thickness direction of the through hole 11.

FIG. 15 is a schematic front sectional view of a partial structure of the electronic device in FIG. 6. When the flexible circuit board 23 is fastened to and assembled with the hinge 10 via the snap-fit member 21 and the first attachment member 22, the end that is of the first attachment member 22 and that faces away from the flexible circuit board 23 may abut against and be attached to the second attachment member 12, and one end that is of the first main body part 211 and that faces away from the flexible circuit board 23 may abut against the inner wall 11b of the through hole 11. In other words, the second attachment member 12, the first attachment member 22, the part of the flexible circuit board 23, and the first main body part 211 are sequentially stacked in the thickness direction, the second attachment member 12 may be fastened to the inner wall 11a (or the groove bottom of the mounting groove) of the through hole 11, and the first main body part 211 may abut against the inner wall 11b of the through hole 11. There is no gap between the second attachment member 12 and the inner wall 11a (or the groove bottom of the mounting groove) of the through hole 11, and there is no gap between the first main body part 211 and the inner wall 11b of the through hole 11. In other words, a stacked structure formed by the second attachment member 12, the first attachment member 22, the flexible circuit board 23, and the first main body part 211 may jointly fill the through hole 11 (and the mounting groove) in the thickness direction, and there may be no gap between the stacked structure and the hinge 10 (or the two inner walls of the through hole 11 in the thickness direction) in the thickness direction. In scenarios such as drop and impact, the flexible circuit board assembly 20 and the hinge 10 are not prone to colliding and moving, so that strength of the hinge assembly 101 against drop is further improved, and a risk of breakage of the hinge 10 is significantly reduced.

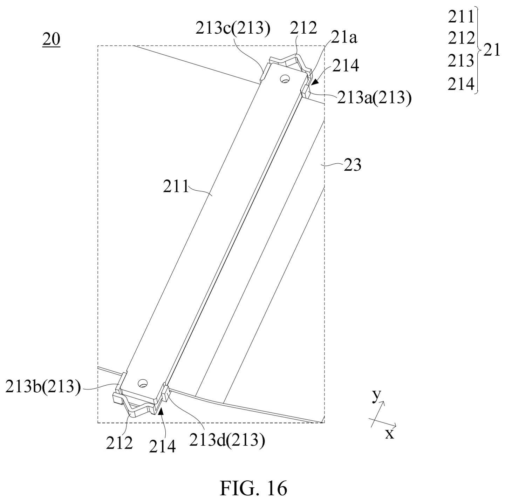

FIG. 16 is a schematic locally enlarged view of a structure of the flexible circuit board assembly in FIG. 7 at the snap-fit member.

For example, as shown in FIG. 16, the snap-fit member 21 may further include a limiting part 213. There may be at least two limiting parts 213, that is, there are a plurality of limiting parts 213. At least two of the plurality of limiting parts 213 are respectively located on two opposite sides of the first main body part 211 in the pass-through direction (x direction). In other words, a part of the limiting parts 213 is located on one side of the two opposite sides of the first main body part 211 in the pass-through direction, and a part of the limiting parts 213 is located on the other side, so that the two opposite sides of the first main body part 211 in the pass-through direction may be provided with at least limiting parts 213.

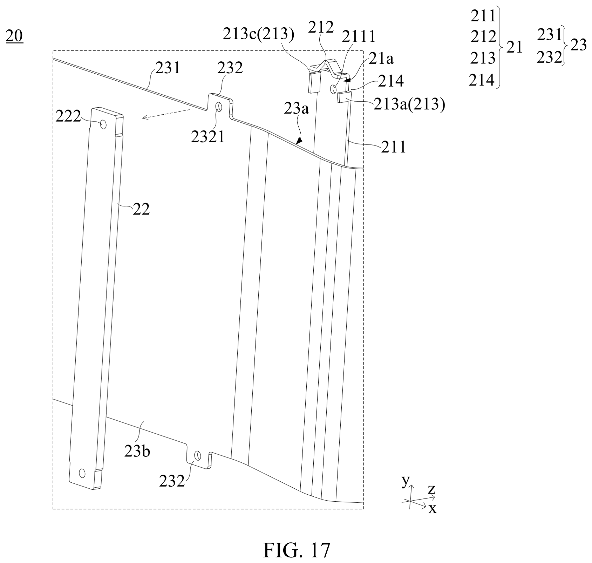

FIG. 17 is another schematic exploded view of a partial structure of the flexible circuit board assembly in FIG. 7.

As shown in FIG. 17, the first attachment member 22 and the first main body part 211 of the snap-fit member 21 are respectively fastened to the second surface 23b and the first surface 23a of the flexible circuit board 23, and the limiting part 213 protrudes from a surface that is of the first main body part 211 and that faces the first attachment member 22. For example, one end of the limiting part 213 may be fastened to the surface that is of the first main body part 211 and that faces the first attachment member 22, and the other end of the limiting part 213 may extend toward the first attachment member 22 and away from the first main body part 211. For example, the other end of the limiting part 213 may extend toward the first attachment member 22 in the thickness direction (z direction), so that the limiting part 213 may protrude from the surface that is of the first main body part 211 and that faces the first attachment member 22, and the plurality of protruding limiting parts 213 and the first main body part 211 may form accommodating space 21a.

The first snap-fit part 212 may also protrude from the surface that is of the first main body part 211 and that faces the first attachment member 22. In other words, one end of the first snap-fit part 212 may be connected to the first main body part 211, and the other end of the first snap-fit part 212 may extend toward the first attachment member 22 and away from the first main body part 211, for example, the other end of the first snap-fit part 212 may extend toward the first attachment member 22 in the thickness direction (z direction), so that the first snap-fit part 212 may protrude from the surface that is of the first main body part 211 and that faces the first attachment member 22, and the first snap-fit part 212, the limiting part 213, and the first main body part 211 jointly form the foregoing accommodating space 21a.

With reference to FIG. 16, the first attachment member 22 is located in the accommodating space 21a formed by the limiting part 213, the first snap-fit part 212, and the first main body part 211. The accommodating space 21a may play a positioning role for assembly of the first attachment member 22 and the snap-fit member 21, and facilitates the assembly. This helps accurately position the first attachment member 22 and the snap-fit member 21, and ensures implementation of an attachment between the first attachment member 22 and the second attachment member 12 when the snap-fit member 21 and the hinge 10 are in the snap-fit.

The limiting parts 213 located on two opposite sides of the first main body part 211 in the pass-through direction may further implement limiting and fastening of the first attachment member 22, to limit displacement of the first attachment member 22 relative to the snap-fit member 21 in the pass-through direction, and improve movement consistency between the snap-fit member 21 and the first attachment member 22 in the pass-through direction, so that damage to the flexible circuit board 23 cannot be caused by pulling the flexible circuit board 23 due to an excessively large displacement amount of adhesive layers such as the first bonding layer 24 and the second bonding layer 25 in a process in which the flexible circuit board 23 is pulled during assembly or disassembly of the flexible circuit board assembly 20.

The first snap-fit parts 212 located on the two opposite ends of the first main body part 211 in the length direction may also limit and fasten the first attachment member 22, to limit displacement of the first attachment member 22 relative to the snap-fit member 21 in the length direction (y direction), further enhance limiting strength between the snap-fit member 21 and the first attachment member 22, and reduce pulling damage to the flexible circuit board 23.

For example, the snap-fit member 21 may be an integrated mechanical part, that is, the first main body part 211, the first snap-fit part 212, and the limiting part 213 may form an integrated mechanical part in an integrated forming manner, so that the first main body part 211, the first snap-fit part 212, and the limiting part 213 have a high bonding firmness, thereby improving stability and strength of the snap-fit member 21.

Alternatively, in some examples, the first main body part 211, the first snap-fit part 212, and the limiting part 213 may be separately formed, and the first main body part 211, the first snap-fit part 212, and the limiting part 213 may be assembled together in a manner of bonding connection, welding connection, snap-fit connection, thread fastening, or the like to form the snap-fit member 21.

There may be two limiting parts 213, and the two limiting parts 213 are respectively located on two opposite sides of the first main body part 211 in the pass-through direction. As shown in FIG. 16, the snap-fit member 21 may include only a limiting part 213a and a limiting part 213b. The limiting part 213a and the limiting part 213b are respectively located on two opposite sides of the first main body part 211 in the pass-through direction. The limiting part 213a, the limiting part 213b, and the first main body part 211 form the accommodating space 21a, to implement positioning and limiting of the first attachment member 22. Alternatively, the snap-fit member 21 may further include only a limiting part 213a and a limiting part 213c. The limiting part 213a and the limiting part 213c are also respectively located on two opposite sides of the first main body part 211 in the pass-through direction, and the limiting part 213a, the limiting part 213c, and the first main body part 211 form the accommodating space 21a. Alternatively, the snap-fit member 21 may further include only a limiting part 213b and a limiting part 213d that are located on two opposite sides of the first main body part 211 in the pass-through direction. Alternatively, the snap-fit member 21 may further include only a limiting part 213c and a limiting part 213d that are located on two opposite sides of the first main body part 211 in the pass-through direction.

Alternatively, there may be more than two limiting parts 213. A part of the limiting parts 213 may be located on one side of two opposite sides of the first main body part 211 in the pass-through direction, and a part of the limiting parts 213 may be located on the other side of the two opposite sides of the first main body part 211 in the pass-through direction. For example, as shown in FIG. 16, there are four limiting parts 213, for example, a limiting part 213a, a limiting part 213b, a limiting part 213c, and a limiting part 213d. For example, the limiting part 213a and the limiting part 213d may be located on one side of two opposite sides of the first main body part 211 in the pass-through direction, and the limiting part 213b and the limiting part 213c may be located on the other side of the two opposite sides of the first main body part 211 in the pass-through direction.

The limiting part 213a, the limiting part 213b, the limiting part 213c, the limiting part 213d, and the first main body part 211 form the accommodating space 21a, to implement positioning and limiting of the first attachment member 22.

To improve positioning and limiting effect of the limiting part 213 on the first attachment member 22, the plurality of limiting parts 213 may be distributed on two opposite ends of the snap-fit member 21 in the length direction (y direction). In other words, a part of the limiting parts 213 may be located at one end of the two opposite ends of the snap-fit member 21 in the length direction, and a part of the limiting parts 213 may be located at the other end. This ensures consistency of positioning and limiting of the first attachment member 22 in the length direction, and enhances positioning and limiting strength of the first attachment member 22.

For example, as shown in FIG. 16, in the four limiting parts 213, the limiting part 213a and the limiting part 213c may be located at one end of the two opposite ends of the first main body part 211 in the length direction, and the limiting part 213b and the limiting part 213d may be located at the other end of the two opposite ends of the first main body part 211 in the length direction. The four limiting parts 213 can have good positioning and limiting effect on the first attachment member 22.

For example, the first main body part 211 may be a rectangular sheet-shaped mechanical part. When the snap-fit member 21 is actually formed, four protruding extension parts may be formed near four corners of the first main body part 211 when the rectangular first main body part 211 is formed, and the four extension parts are bent, so that the extension parts protrude from a surface of the first main body part 211, to form the four limiting parts 213.

It may be understood that, to avoid the flexible circuit board 23 between the first main body part 211 and the first attachment member 22, there may be an avoidance gap between the limiting parts 213 distributed at the two opposite ends of the snap-fit member 21 in the length direction. A part of the flexible circuit board 23 is located in the avoidance gap, to avoid the flexible circuit board 23, so that the flexible circuit board 23 can be smoothly fastened between the first main body part 211 and the first attachment member 22, thereby reducing damage to the flexible circuit board 23. For example, as shown in FIG. 16, the limiting part 213a and the limiting part 213d (or the limiting part 213b) are used as an example. There is a gap between the limiting part 213a and the limiting part 213d (or the limiting part 213b) in the length direction to form an avoidance gap (as shown in FIG. 18). A part of the flexible circuit board is located between the snap-fit member and the first attachment member, and a part of the flexible circuit board passes through the avoidance gap. For example, the limiting part 213c and the limiting part 213b (or the limiting part 213d) are used as an example, and there is also a gap between the limiting part 213c and the limiting part 213b (or the limiting part 213d) in the length direction to form an avoidance gap.

It should be noted that, when there are two limiting parts 213, the two limiting parts 213 may also be respectively located at two opposite ends of the first main body part 211 in the length direction. As shown in FIG. 16, that only the limiting part 213a and the limiting part 213b are included is used as an example. The limiting part 213a and the limiting part 213b are respectively located at two ends of the first main body part 211 in the length direction, and the limiting part 213a and the limiting part 213b are also respectively located on two sides of the first main body part 211 in the pass-through direction.

Alternatively, the two limiting parts 213 may be respectively located on two sides of the first main body part 211 in the pass-through direction, and each limiting part 213 may extend in the length direction. For example, two ends of each limiting part 213 may respectively extend to two opposite ends of the first main body part 211 in the length direction.

Alternatively, in some examples, to improve positioning and limiting effect of the limiting part 213 on the first attachment member 22, the limiting part 213 may have a specific length. For example, there are two limiting parts 213. The two limiting parts 213 may be located at one end of the first main body part 211 in the length direction, and the two limiting parts 213 are respectively located on two opposite sides of the first main body part 211 in the pass-through direction. For example, the snap-fit member 21 includes only the limiting part 213a and the limiting part 213c (as shown in FIG. 16). A length of each limiting part 213 may occupy a large proportion of a length of the first main body part 211. For example, the length of the limiting part 213 may be half of the length of the first main body part 211. A contact limiting area between the limiting part 213 and the first attachment member 22 in the length direction is increased, so that positioning and limiting effect of the first attachment member 22 can be improved.

To avoid the flexible circuit board 23, for example, a through opening may be formed on each limiting part 213, so that the flexible circuit board 23 passes through the through opening of the limiting part 213. This can also ensure good limiting and positioning effect on the flexible circuit board 23, and reduce damage to the flexible circuit board 23.

As shown in FIG. 17, the flexible circuit board 23 may include a second main body part 231 and an extension part 232. For example, two extension parts 232 may be respectively disposed on two sides of the second main body part 231 in the length direction. The extension part 232 and a part of the second main body part 231 may be located in the accommodating space 21a of the snap-fit member 21, and a part of the second main body part 231 may pass through the avoidance gap between the limiting parts 213 or the through opening of the limiting part 213. The extension part 232 is located in the accommodating space 21a, to play a positioning role for assembly of the snap-fit member 21 and the flexible circuit board 23, and implement accurate positioning and assembly of the snap-fit member 21 on the flexible circuit board 23, thereby facilitating accurate positioning of the snap-fit member 21 and the first attachment member 22 on the flexible circuit board 23 during assembly.

For example, the first attachment member 22, the part of the flexible circuit board 23, and the first main body part 211 are sequentially stacked, so that projections (projections in the thickness direction) of two opposite ends of the first main body part 211 in the length direction, two extension parts 232, and two opposite ends of the first attachment member 22 in the length direction may at least partially overlap, and the extension parts 232 are respectively located at two ends of the accommodating space 21a formed by the snap-fit member 21 in the length direction, to better implement assembly and positioning of the flexible circuit board 23, the snap-fit member 21, and the first attachment member 22, thereby improving positioning accuracy.

For example, an overlapping area of projections the two ends of the first main body part 211, the two extension parts 232, and the two opposite ends of the first attachment member 22 may be maximized in the length direction. For example, the two ends of the first main body part 211, the two extension parts 232, and the two ends of the first attachment member 22 almost overlap, so that accuracy of assembly and positioning of the flexible circuit board 23, the snap-fit member 21, and the first attachment member 22 can be further improved.

In some embodiments, a first positioning hole 2111 may be disposed at each of the two ends of the first main body part 211 in the length direction, and the first positioning hole 2111 may penetrate the first main body part 211 in the thickness direction. A second positioning hole 2321 may be disposed on each of the two extension parts 232, and the second positioning hole 2321 may also penetrate the extension part 232 in the thickness direction. A third positioning hole 222 may be disposed at each of the two ends of the first attachment member 22 in the length direction, and the third positioning hole 222 may also penetrate the first attachment member 22 in the thickness direction.

Center lines of the first positioning hole 2111, the second positioning hole 2321, and the third positioning hole 222 may overlap in the thickness direction. The first positioning hole 2111, the second positioning hole 2321, and the third positioning hole 222 may be configured to implement auxiliary positioning for the first main body part 211, the snap-fit member 21, and the flexible circuit board 23 during assembly, to further improve positioning accuracy.

For example, when the snap-fit member 21, the flexible circuit board 23, and the first attachment member 22 are assembled, after the first attachment member 22, the part of flexible circuit board 23, and the snap-fit member 21 are sequentially stacked, a positioning rod may be used to enable the positioning rod to successively pass through the first positioning hole 2111, the second positioning hole 2321, and the third positioning hole 222 in the thickness direction, and the positioning rod may overlap the center lines of the first positioning hole 2111, the second positioning hole 2321, and the third positioning hole 222. In this way, the snap-fit member 21, the flexible circuit board 23, and the first attachment member 22 implement accurate positioning and assembly.

For example, a hole diameter of the first positioning hole 2111 may be equal to a hole diameter of the third positioning hole 222, and a hole diameter of the second positioning hole 2321 may be separately greater than the hole diameter of the first positioning hole 2111 and the hole diameter of the third positioning hole 222. The hole diameter of the second positioning hole 2321 on the flexible circuit board 23 is large, so that collision or contact between the positioning rod and a circuit structure on the flexible circuit board 23 may be reduced or avoided in an assembly process, for example, when the positioning rod is used to assist positioning, to ensure electrical connection performance of the flexible circuit board 23.

FIG. 18 is a diagram of a structure of the snap-fit member in FIG. 16.

As shown in FIG. 18, the snap-fit member 21 further includes a notch structure 214, and the notch structure 214 may be located on one side of the snap-fit member 21. For example, the notch structure 214 may be located on one side of the first main body part 211 in the pass-through direction.

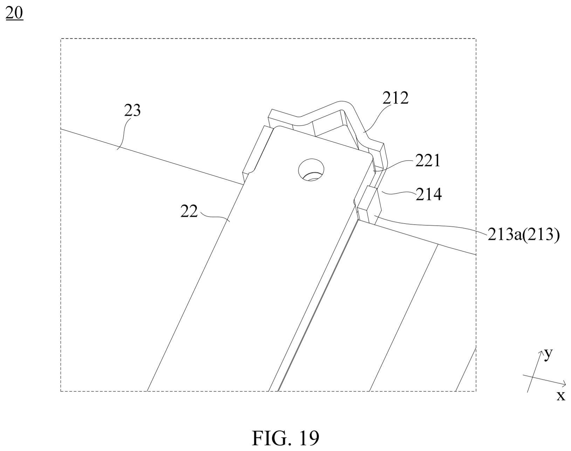

FIG. 19 is a schematic locally enlarged view of a structure of the flexible circuit board assembly in FIG. 16 at one end of the snap-fit member.

As shown in FIG. 19, a first abutting surface 221 is provided on one side of the first attachment member 22 in the pass-through direction (x direction), the first attachment member 22 is located in the accommodating space 21a of the snap-fit member 21, and the first abutting surface 221 of the first attachment member 22 may be exposed from the notch structure 214 on the snap-fit member 21, for example, the first abutting surface 221 may be exposed from the notch structure 214 in the pass-through direction.

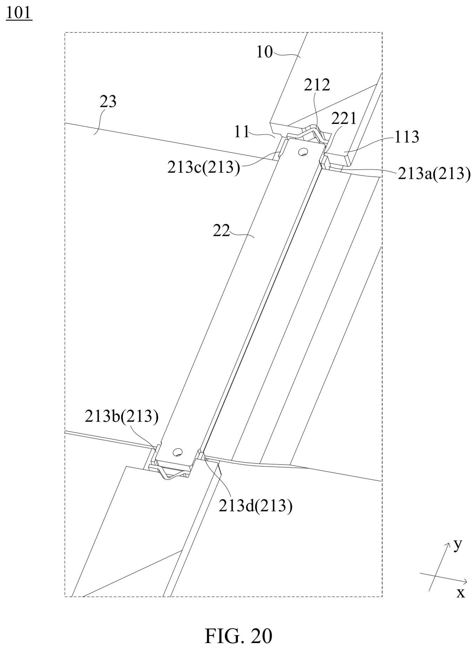

FIG. 20 is another schematic sectional view of a structure of the hinge assembly in FIG. 9.

With reference to FIG. 20, a first boss 113 may be provided in the through hole 11 of the hinge 10, and the first boss 113 may be located on a side of the pass-through direction in the through hole 11. After the flexible circuit board assembly and the hinge 10 are assembled to form the hinge assembly 101, the first boss 113 may at least partially extend into the notch structure 214 (not shown in the figure) of the snap-fit member 21, and the first abutting surface 221 of the first attachment member 22 abuts against the first boss 113, so that displacement of the flexible circuit board 23 in the pass-through direction may be limited.

When the flexible circuit board assembly and the hinge 10 are assembled, the pass-through direction of the flexible circuit board 23 on the hinge 10 or an insertion direction of the snap-fit member 21 on the hinge 10 may be a direction from the first abutting surface 221 to the first boss 113. For example, the pass-through direction may be a direction from x to right in the figure.

In this way, when the flexible circuit board 23 is pulled in the pass-through direction, for example, the flexible circuit board 23 is pulled rightward in the x direction in the figure, to assemble the flexible circuit board assembly with the hinge 10, abutting of the first abutting surface 221 against the first boss 113 can limit further rightward movement of the flexible circuit board assembly 20 in the pass-through direction, thereby implementing accurate positioning of the snap-fit member 21 and the first attachment member 22 on the hinge 10, and avoiding damage caused by pulling the flexible circuit board 23. For example, in a process of pulling the flexible circuit board 23, when the first boss 113 abuts against the first abutting surface 221, it can be ensured that the first snap-fit part 212 is in the snap-fit with the second snap-fit part 111, and the first attachment member 22 is attached to the second attachment member 12, to avoid problems such as excessively pulling of the flexible circuit board 23 or an inaccurate assembly.

For example, there may be at least two notch structures 214 on the snap-fit member 21 (as shown in FIG. 18), and a quantity of first bosses may be corresponding to a quantity of notch structures 214. The at least two notch structures 214 may be distributed on two ends of the snap-fit member 21 in the length direction (y direction), so that limiting consistency and limiting strength of moving the flexible circuit board 23 in the pass-through direction in an assembly process can be improved, thereby further facilitating accurate positioning and assembly.

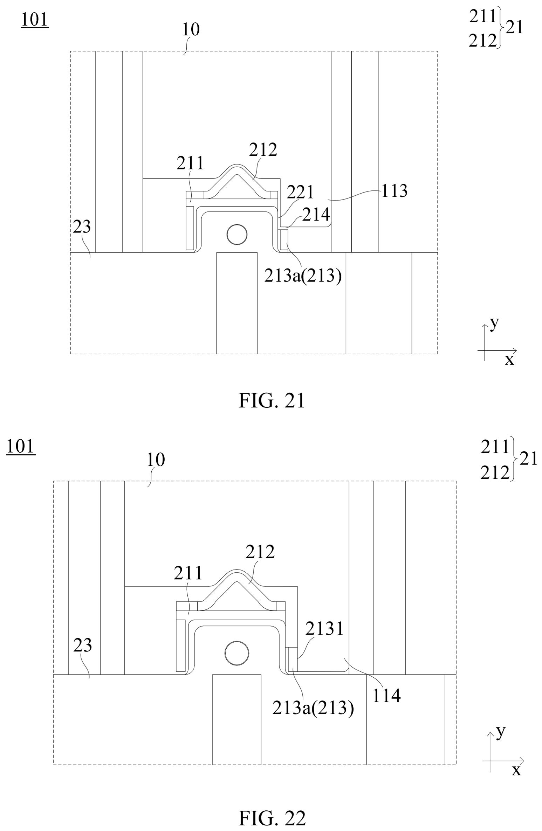

FIG. 21 is a schematic locally enlarged sectional view of a structure of the hinge assembly in 20. With reference to FIG. 21, the limiting part 213, for example, the limiting part 213a (and the limiting part 213d, as shown in FIG. 18), is disposed on one side of the first main body part 211 in the pass-through direction, and the notch structure 214 may be located between the limiting part 213a and the first snap-fit part 212, to facilitate forming implementation. For example, when the extension part is formed on the first main body part 211 to form the limiting part 213a in a bending manner, a gap may exist between the extension part and the first snap-fit part 212 of the end part, so that the notch structure 214 may be formed between the limiting part 213a and the first snap-fit part 212 after the limiting part 213a is formed. The forming manner is simple and easy to implement, facilitating costs reduction.

In addition, the first abutting surface 221 of the first attachment member 22 abuts against the first boss 113, to reduce impact on the snap-fit member 21 in an assembly process of the flexible circuit board assembly 20, so that firmness of bonding between the snap-fit member 21 and the flexible circuit can also be ensured when a width (a width in the pass-through direction) of the first bonding layer 24 located between the snap-fit member 21 and the flexible circuit board 23 is narrow.

For example, as shown in FIG. 15, a width of the first bonding layer 24 located between the snap-fit member 21 and the flexible circuit board 23 may be less than a width of the second bonding layer 25 between the first attachment member 22 and the flexible circuit board 23.

A foldable device with a screen folded outward is used as an example. The flexible display is located on an outer surface side of the hinge assembly. An outer surface of the hinge assembly and an outer surface of the hinge (for example, an outer surface of the hinge 10 in FIG. 15) are located on a same surface, and an inner surface of the hinge assembly and an inner surface of the hinge (for example, an inner surface of the hinge 10 in FIG. 15) are located on a same surface. In a structure in which the first main body part 211 of the snap-fit member 21, the part of the flexible circuit board 23, and the second attachment member 12 are sequentially stacked, the snap-fit member 21 is closer to the inner surface of the hinge 10, and the second attachment member 12 is closer to the outer surface of the hinge 10. To be specific, in the thickness direction (for example, the z direction in FIG. 15), the flexible display is located on a side that is of the second attachment member 12 and that faces away from the snap-fit member 21.

The first surface 23a of the flexible circuit board 23 is closer to the inner surface of the hinge 10, and the second surface 23b of the flexible circuit board 23 is closer to the outer surface of the hinge 10. When the first middle frame 102a and the second middle frame 102b rotate (still as shown in FIG. 15), rotation of the two middle frames drives the flexible circuit board 23 to bend. In this way, when the electronic device is in a folded state, a part that is of the first surface 23a of the flexible circuit board 23 and that is located in the first middle frame 102a is opposite to a part located in the second middle frame 102b, and a part that is of the second surface 23b of the flexible circuit board 23 and that is located in the first middle frame 102a is opposite to a part located in the second middle frame 102b.

The width of the first bonding layer 24 between the snap-fit member 21 and the first surface 23a is less than the width of the second bonding layer 25 between the first attachment member 22 and the second surface 23b, the width of the first bonding layer 24 is narrow, and the first bonding layer 24 imposes a small constraint on the first surface 23a in the width direction, so that impact of the first bonding layer 24 on bending of the flexible circuit board 23 can be reduced or avoided, to facilitate bending of the flexible circuit board 23.

FIG. 22 is another schematic locally enlarged sectional view of a structure of a hinge assembly according to an embodiment of this application.

In some other embodiments, the limiting part 213 may also abut against the first boss. For example, as shown in FIG. 22, the limiting part 213, for example, the limiting part 213a, is disposed on a side of the first main body part 211 in the pass-through direction, and a surface that is of the limiting part 213a and that faces away from the accommodating space may form a second abutting surface 2131. A second boss 114 may also be provided in the through hole of the hinge 10. The second boss 114 is located on a side of the pass-through direction in the through hole, and the second abutting surface 2131 on the limiting part 213 abuts against the second boss 114, which may also limit displacement of the flexible circuit board 23 in the pass-through direction.

Correspondingly, when the flexible circuit board assembly 20 and the hinge 10 are assembled, the pass-through direction of the flexible circuit board 23 may also be a direction from the second abutting surface 2131 to the second boss 114. When the flexible circuit board 23 is pulled in the pass-through direction to implement assembly, the second abutting surface 2131 abuts against the second boss 114, so that the flexible circuit board assembly 20 can be continued to be limited relative to the hinge 10, thereby avoiding damage caused by pulling the flexible circuit board 23. For example, there may also be at least two the second bosses 114 and the limiting parts 213 that abut against the second bosses 114. For example, the limiting parts 213 (for example, the limiting part 213a and the limiting part 213d in FIG. 20) that are located on one side of the first main body part 211 in the pass-through direction and that are respectively located on two opposite ends of the first main body part 211 in the length direction may abut against the first boss 113, and limiting strength of the flexible circuit board 23 can be further improved, to ensure accurate positioning and assembly.

It should be noted that, in some other examples, the notch structure (for example, as shown in the notch structure 214 in FIG. 19) may be formed at one end of the snap-fit member in the length direction, to expose the first abutting surface of the first attachment member at the end, and the second abutting surface is provided on the limiting part (for example, as shown in the limiting part 213a in FIG. 22) at the other end of the snap-fit member in the length direction. The first boss and the second boss may be separately disposed in the through hole of the hinge. The first boss and the second boss may be distributed at an interval in the length direction. The first abutting surface exposed from the notch structure at one end of the snap-fit member may abut against the first boss, and the second abutting surface of the limiting part at the other end of the snap-fit member may abut against the second boss, to limit movement of the flexible circuit board assembly in the pass-through direction, thereby implementing accurate positioning and assembly.

In descriptions of embodiments of this application, it should be noted that, unless otherwise clearly specified and limited, the term "mounting", "connection to", or "connection" should be understood in a broad sense, for example, may be fastening, or may be an indirect connection through an intermediate medium, or may be internal communication between two elements or an interaction relationship between two elements. A person of ordinary skill in the art may understand specific meanings of the foregoing terms in embodiments of this application based on specific cases. The terms such as "first", "second", "third", "fourth", and the like (if any) are intended to distinguish between similar objects but do not necessarily indicate a specific order or sequence.

Finally, it should be noted that the foregoing embodiments are merely used to describe the technical solutions in embodiments of this application, but not to limit the technical solutions. Although embodiments of this application are described in detail with reference to the foregoing embodiments, a person of ordinary skill in the art should understand that the technical solutions recorded in the foregoing embodiments may still be modified, or some or all of technical features thereof may be equivalently replaced. However, these modifications or replacements do not depart from the scope of the technical solutions in embodiments of this application.

## Claims

1. A flexible circuit board assembly, configured to cooperate with a hinge of a foldable electronic device, comprising:
a flexible circuit board, wherein the flexible circuit board is configured to pass through the hinge through a through hole of the hinge, and a pass-through direction of the flexible circuit board intersects with a thickness direction of the hinge and a length direction of the hinge;
a first attachment member, wherein the first attachment member is disposed on the flexible circuit board, and one end that is of the first attachment member and that faces away from the flexible circuit board in the thickness direction of the hinge is configured to be attached to a second attachment member in the hinge; and
a snap-fit member, wherein the snap-fit member is disposed on the flexible circuit board, and the snap-fit member is configured to be inserted into the through hole in the pass-through direction, and be in a snap-fit with the hinge.

2. The flexible circuit board assembly according to claim 1, wherein the flexible circuit board comprises a first surface and a second surface that are opposite in the thickness direction; and
at least a part of the snap-fit member and the first attachment member are respectively located on the first surface and the second surface, the at least part of the snap-fit member, a part of the flexible circuit board, and the first attachment member are sequentially stacked in the thickness direction, the end that is of the first attachment member and that faces away from the flexible circuit board is configured to abut against the second attachment member, and one end that is of the at least part of the snap-fit member and that faces away from the flexible circuit board is configured to abut against an inner wall that is of the through hole and that is opposite to the second attachment member in the thickness direction.

3. The flexible circuit board assembly according to claim 2, wherein the snap-fit member comprises a first main body part and at least two limiting parts, and the first main body part is attached and fastened to the first surface; and
at least two of the limiting parts are respectively located on two opposite sides of the first main body part in the pass-through direction, the limiting part protrudes from a surface that is of the first main body part and that faces the first attachment member, the limiting part and the first main body part form accommodating space, and the first attachment member is located in the accommodating space.

4. The flexible circuit board assembly according to claim 3, wherein at least two of the limiting parts are respectively distributed on two opposite ends of the first main body part in the length direction; and
an avoidance gap is provided between the limiting parts distributed on the two opposite ends of the snap-fit member in the length direction, and a part of the flexible circuit board is located in the avoidance gap.

5. The flexible circuit board assembly according to claim 3 or 4, wherein the snap-fit member further comprises a first snap-fit part; and
the first snap-fit part is disposed on each of the two opposite ends of the first main body part in the length direction, and the first snap-fit part is configured to be in a snap-fit with a second snap-fit part in the through hole.

6. The flexible circuit board assembly according to claim 5, wherein the first snap-fit part protrudes from the surface that is of the first main body part and that faces the first attachment member, and the first snap-fit part, the limiting part, and the first main body part jointly form the accommodating space.

7. The flexible circuit board assembly according to claim 5 or 6, wherein the first snap-fit part and the second snap-fit part are in a snap-fit with a recessed groove through an elastic protrusion.

8. The flexible circuit board assembly according to claim 7, wherein the first snap-fit part comprises a connecting arm and a snap-fit arm, and the connecting arm is connected to the first main body part; and
the connecting arm is provided on each of two sides of the snap-fit arm in the pass-through direction, two end parts of the snap-fit arm are respectively connected to the connecting arms, and a middle part of the snap-fit arm protrudes away from the accommodating space to form the elastic protrusion.

9. The flexible circuit board assembly according to any one of claims 5 to 8, wherein a first abutting surface is provided on a side of the first attachment member in the pass-through direction; and
the snap-fit member further comprises a notch structure, wherein the notch structure is located on a side of the first main body part in the pass-through direction, the first abutting surface is exposed from the notch structure, the notch structure is configured to accommodate a part of a first boss in the through hole, and the first abutting surface is configured to abut against and fit the first boss.

10. The flexible circuit board assembly according to claim 9, wherein the notch structure is provided between the first snap-fit part and the limiting part located on the side of the first main body part in the pass-through direction.

11. The flexible circuit board assembly according to any one of claims 3 to 10, wherein a surface that is of the limiting part located on the side of the first main body part in the pass-through direction and that faces away from the accommodating space forms a second abutting surface, and the second abutting surface is configured to abut against and fit the first boss in the through hole.

12. The flexible circuit board assembly according to claim 9 or 10, further comprising a first bonding layer, wherein the first bonding layer is located between the first main body part and the first surface, and the snap-fit member and the flexible circuit board are fastened through the first bonding layer;
the flexible circuit board further comprises a second bonding layer, the second bonding layer is located between the flexible circuit board and the first attachment member, and the first attachment member and the flexible circuit board are fastened through the second bonding layer; and
a width of the first bonding layer in the pass-through direction is less than a width of the second bonding layer in the pass-through direction.

13. The flexible circuit board assembly according to any one of claims 3 to 12, wherein the flexible circuit board comprises a second main body part and an extension part, the extension part is located on two sides of the second main body part in the length direction, and the extension part and a part of the second main body part are located in the accommodating space.

14. The flexible circuit board assembly according to claim 13, wherein a first positioning hole is provided on each of two ends of the first main body part in the length direction, a second positioning hole is provided on the extension part, a third positioning hole is provided on each of two ends of the first attachment member in the length direction, and center lines of the first positioning hole, the second positioning hole, and the third positioning hole overlap in the thickness direction.

15. The flexible circuit board assembly according to claim 14, wherein a hole diameter of the first positioning hole is equal to a hole diameter of the third positioning hole, and a hole diameter of the second positioning hole is separately greater than the hole diameter of the first positioning hole and the hole diameter of the second positioning hole.

16. A hinge assembly, comprising at least a hinge and the flexible circuit board assembly according to any one of claims 1 to 15, wherein a through hole is provided on the hinge, and a second attachment member is disposed in the hinge; and
the flexible circuit board passes through the hinge through the through hole, one end that is of the first attachment member and that faces away from the flexible circuit board in a thickness direction of the hinge is attached to the second attachment member, and the snap-fit member is inserted into the through hole in a pass-through direction of the flexible circuit board, and is in a snap-fit with the hinge.

17. The hinge assembly according to claim 16, wherein the second attachment member is located on an inner side wall of the through hole in the thickness direction; and
the second attachment member, the first attachment member, a part of the flexible circuit board, and at least a part of the snap-fit member are sequentially stacked in the thickness direction, and one end that is of the at least part of the snap-fit member and that faces away from the flexible circuit board abuts against an inner wall that is of the through hole and that is opposite to the second attachment member in the thickness direction.

18. The hinge assembly according to claim 17, wherein a second snap-fit part is disposed on each of two opposite inner side walls of the through hole in the length direction, and the second snap-fit part and a first snap-fit part of the snap-fit member are in a snap-fit with a recessed groove through an elastic protrusion.

19. The hinge assembly according to any one of claims 16 to 18, wherein a mounting groove is provided on an inner wall of the through hole, and the second attachment member is disposed in the mounting groove.

20. The hinge assembly according to any one of claims 16 to 19, wherein the through hole is provided with a protruding first boss, and the first boss is located on a side of the pass-through direction in the through hole; and
the first boss partially extends into a notch structure on the snap-fit member, and the first boss abuts against and fits a first abutting surface on the first attachment member.

21. The hinge assembly according to any one of claims 16 to 20, wherein the through hole is provided with a protruding second boss, and the second boss is located on a side of the pass-through direction in the through hole; and
the second boss abuts against and fits a second abutting surface on a limiting part of the snap-fit member.

22. A foldable electronic device, comprising at least two middle frames and the hinge assembly according to any one of claims 16 to 21, wherein the two middle frames are respectively located on two sides of the hinge assembly, and the two middle frames are in a rotatable fit through the hinge assembly.

23. The foldable electronic device according to claim 22, further comprising a flexible display, wherein the flexible display is disposed on the hinge assembly and the middle frames; and
the flexible display is located at least on outer surfaces of the middle frames and the hinge assembly, and when the electronic device is in a folded state, the outer surfaces of the two middle frames face away from each other, and the outer surface of the hinge assembly and the outer surfaces of the middle frames are located on a same side of the electronic device.

24. The foldable electronic device according to claim 23, wherein in the thickness direction, the flexible display is located on a side that is of the second attachment member and that faces away from the snap-fit member.
